(19) Europäisches Patentamt
European Patent Office
Office européen des brevets

(11) **EP 3 660 523 B1**

(12) **EUROPÄISCHE PATENTSCHRIFT**

(45) Veröffentlichungstag und Bekanntmachung des Hinweises auf die Patenterteilung:
**19.04.2023  Patentblatt 2023/16**

(21) Anmeldenummer: **18208595.1**

(22) Anmeldetag: **27.11.2018**

(51) Internationale Patentklassifikation (IPC):
**G01R 31/08** *(2020.01)*    **G01R 19/25** *(2006.01)*

(52) Gemeinsame Patentklassifikation (CPC):
**G01R 31/086; G01R 19/2506;** Y04S 10/52

(54) **VERFAHREN, EINRICHTUNG UND SYSTEM ZUM ERMITTELN DES FEHLERORTES EINES FEHLERS AUF EINER LEITUNG EINES ELEKTRISCHEN ENERGIEVERSORGUNGSNETZES**

METHOD, DEVICE AND SYSTEM FOR DETERMINING THE LOCATION OF A FAULT ON A LINE OF AN ELECTRICAL ENERGY SUPPLY NETWORK

PROCÉDÉ, DISPOSITIF ET SYSTÈME DESTINÉS À DÉTERMINER L'EMPLACEMENT D'UN DÉFAUT SUR UNE LIGNE D'UN RÉSEAU D'ALIMENTATION D'ÉNERGIE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**03.06.2020  Patentblatt 2020/23**

(73) Patentinhaber: **Siemens Aktiengesellschaft 80333 München (DE)**

(72) Erfinder:
• **Dzienis, Cezary**
  **14624 Dallgow-Döberitz (DE)**
• **Jurisch, Andreas**
  **16727 Schwante (DE)**

(74) Vertreter: **Siemens Patent Attorneys Postfach 22 16 34 80506 München (DE)**

(56) Entgegenhaltungen:
**EP-A1- 3 223 026    EP-A1- 3 477 808**

**Beschreibung**

Die Erfindung betrifft ein Verfahren zum Ermitteln des Fehlerortes eines Fehlers auf einer Leitung eines elektrischen Energieversorgungsnetzes, wobei an den Leitungsenden der Leitung mittels Einrichtungen transiente Verläufe von Strom- und Spannungswerten gemessen werden und unter Verwendung der transienten Verläufe Strom- und Spannungswerte nach dem Auftreten eines Fehlers auf der Leitung dessen Fehlerort bestimmt wird. Die Erfindung betrifft außerdem eine Einrichtung zur Durchführung eines solchen Verfahrens sowie ein System mit einer solchen Einrichtung.

Der sichere Betrieb elektrischer Energieversorgungsnetze erfordert die schnelle und zuverlässige Erkennung und Abschaltung etwaiger Fehler, wie z.B. Kurzschlüssen oder Erdschlüssen. Fehlerursachen, die eine Abschaltung bewirken, können beispielsweise Blitzeinschläge, gerissene oder anderweitig schadhafte Leitungen, fehlerhafte Isolierungen bei Kabelleitungen oder die ungewollte Berührung von Freileitungen mit Tier- oder Pflanzenteilen sein. Zur Verkürzung von fehlerbedingten Ausfallzeiten müssen solche Fehler möglichst genau lokalisiert werden, um eine Behebung der Fehlerursache und etwaiger durch den Fehler herbeigeführter Folgeschäden durch ein Wartungsteam zu ermöglichen.

Der Fehlerort, an dem sich der Fehler auf der Leitung befindet, kann mittels einer Analyse von während des Fehlereintritts erfassten Messgrößen, z.B. Strömen und Spannungen, eingegrenzt werden. Hierfür sind mittlerweile mehrere unterschiedliche Verfahren bekannt, deren Genauigkeit sich signifikant auf den Wartungsaufwand des Energieversorgungsnetzes auswirkt. Daher wird großer Wert darauf gelegt, die Genauigkeit der für die Fehlerortung eingesetzten Algorithmen zu verbessern, um die Wartung zu erleichtern und insbesondere fehlerbedingte Ausfallzeiten des Energieversorgungsnetzes zu verkürzen.

Verfahren zur genaueren Fehlerortung verwenden beispielsweise die gemessenen Strom- bzw. Spannungssignale der Grundwelle (50Hz- bzw. 60Hz-Signale) zur Fehlerortung. Hierbei sind Verfahren bekannt, die Messwerte von nur einem der Leitungsenden (einseitige Fehlerortung) oder Messwerte von beiden Leitungsenden (zweiseitige Fehlerortung) verwenden. Als Ergebnis wird der Fehlerort in der Regel als Entfernung von der jeweiligen Messstelle (in Prozent der Leitung oder in km bzw. Meilen) angegeben. Im Fall der Verwendung von Messwerten nur eines Leitungsendes ist der Aufwand zur Durchführung der Fehlerortung gering. Bei dieser Fehlerortungsmethode handelt es sich überwiegend um eine impedanzbasierte Methode, bei der aus Strom- und Spannungsmesswerten eine Impedanz bis zum Fehlerort berechnet wird. Durch Vergleich mit der Leitungsimpedanz der gesamten Leitung im fehlerfreien Fall lässt sich ein Rückschluss auf den Fehlerort ziehen. Eine beispielhafte Ausführung eines solchen Fehlerortungsverfahrens kann beispielsweise der US-Patentschrift US 4996624 A entnommen werden. Die Genauigkeit dieser Methode hängt unter anderem stark von der Messgenauigkeit der verwendeten Strom- und Spannungswandler, der Genauigkeit der zur Fehlerortung verwendeten Leitungsparameter (z.B. Impedanzbelag) sowie von den gegebenen Fehlerbedingungen (z.B. Fehlerwiderstand, Last) und der Netzbeschaffenheit ab. Störungen und die Einschwingvorgänge in den Strom- und Spannungssignalen können sich negativ auf die Genauigkeit dieser Methode auswirken. Die dadurch entstehenden Messfehler können mehrere Prozent betragen. Eine verbesserte Genauigkeit bei der Fehlerortung lässt sich durch die Verwendung von Messwerten von beiden Leitungsenden erreichen. Hierbei müssen die fehlerortungsbezogenen Messwerte über eine geeignete Kommunikationsverbindung zusammengeführt werden. In diesem Zusammenhang sei auf die US-Patentschrift US 5,929,642 verwiesen; bei dem dort beschriebenen Verfahren wird unter Verwendung von Strom- und Spannungsmesswerten von beiden Leitungsenden mithilfe von Schätzverfahren und nichtlinearen Optimierungsverfahren eine recht hohe Genauigkeit (Messfehler ca. 1-2%) bei der Fehlerortung erreicht.

Während die Genauigkeit der Fehlerortung bei den impedanzbasierten Fehlerortungsverfahren von der Messgenauigkeit der verwendeten Messwandler sowie der Netzbeschaffenheit abhängt, lässt sich durch die Verwendung eines Fehlerortungsverfahrens nach dem sogenannten Wanderwellen-Prinzip ("Traveling Wave Fault Location") eine weitgehende Unabhängigkeit von diesen Größen erreichen. Nach diesem Prinzip werden anstelle der Grundwellen der gemessenen Strom- und Spannungssignale die beim Fehler entstehenden transienten Signalanteile, die in Form von sogenannten "Wanderwellen" auftreten, zur Fehlerortung in Betracht gezogen. Hierbei werden die hochfrequenten Wanderwellen-Flanken messtechnisch erfasst und mit einem Zeitstempel versehen. Da die Propagationsgeschwindigkeit der Wanderwellen etwa bei der Lichtgeschwindigkeit liegt, lässt sich aus der Auswertung der Zeitstempelung die Ortung des Fehlers gut durchführen. Mit diesem Fehlerortungsverfahren können Genauigkeiten im Bereich von wenigen Dutzend Metern erreicht werden. Ein Beispiel eines solchen Fehlerortungsverfahrens kann der US-Patentschrift US 8,655,609 B2 entnommen werden.

Ein anderes Verfahren zur Fehlerortung mit Wanderwellen, bei dem anstelle der Flanken eine Mustererkennung längerer zeitlicher Verläufe von Strom und/oder Spannung durchgeführt wird, ist zudem beispielsweise aus der Europäischen Patentanmeldung EP 3 193 420 A1 bekannt.

Aus EP 3 223 026 A1 ist ein weiteres Verfahren zur Fehlerortung bekannt.

Die genannten Fehlerortungsverfahren eignen sich besonders für lineare Netztopologien ohne Verzweigungen, also für Leitungen mit zwei Leitungsenden. Eine schnelle Integration von regenerativen Energiequellen in sowie der Ausbau von bestehenden Energienetzen erfordern in vielen Situationen jedoch den Aufbau von Netztopologien, die von einem üblichen linearen Aufbau abweichen. Dabei werden häufig verzweigte Strukturen geschaffen, die als Zusammenfassung mehrerer Dreibein-Strukturen (oder T-Strukturen) mit mehr als zwei Leitungsenden aufgefasst werden können. Diese erfreuen sich auch aus wirtschaftlichen Gründen großer Beliebtheit. Oftmals stellen solche Strukturen - auch im Vergleich mit der linearen Netztopologie - die einzige praktikable Alternative für einen erforderlichen Netzausbau dar. Somit steigt die Anzahl an Energieversorgungsnetzen, die zumindest teilweise die beschriebenen verzweigten Strukturen aufweisen.

Allerdings stellen solche verzweigten Strukturen der Netztopologie aus Sicht der Netzführung, der Netzüberwachung sowie des Netzschutzes eine große Herausforderung dar. Insbesondere kann es bei komplexen verzweigten Strukturen zu falschen Reaktionen von Schutzeinrichtungen kommen, so dass beispielsweise im Falle eines Netzfehlers eine korrekte Abschaltung des betroffenen Leitungsabschnitts nicht mehr gewährleistet werden kann. Schwierigkeiten bestehen außerdem auch bei der Ortung des Fehlers in solchen Netzstrukturen, so dass die Ergebnisse einer Fehlerortung oft unsicher sind, was bei der Wartung der Leitungen zu den erheblichen Aufwänden führt.

EP 3 477 808 A1, das ein Verfahren zum Erkennen eines Fehlers auf einer Leitung eines elektrischen Energieversorgungsnetzes offenbart, fällt unter Art. 54(3) EPÜ.

Ausgehend von einem Verfahren und einer Einrichtung der eingangs angegebenen Art liegt der Erfindung die Aufgabe zugrunde, eine Fehlerortung bei einer Leitung mit mehr als zwei Leitungsenden auch dann mit hoher Genauigkeit durchführen zu können, wenn nicht an allen Stellen der Leitung Messungen erfolgen.

Diese Aufgabe wird durch ein Verfahren der eingangs angegebenen Art gelöst, bei dem die Leitung einen ersten Leitungsabschnitt mit einem ersten Leitungsende, einen zweiten Leitungsabschnitt mit einem zweiten Leitungsende und zumindest einen weiteren Leitungsabschnitt mit einem weiteren Leitungsende sowie zumindest einen Knotenpunkt aufweist, an dem sich mehr als zwei der Leitungsabschnitte treffen, transiente Verläufe eines Knotenstroms und einer Knotenspannung an dem zumindest einen Knotenpunkt unter Verwendung zumindest der Strom- und Spannungswerte eines Leitungsendes sowie eines Wanderwellenmodells für den jeweiligen Leitungsabschnitt bestimmt werden und für jeden Leitungsabschnitt unter Verwendung einerseits des transienten Verlaufs der an dessen Leitungsende gemessenen Strom- und Spannungswerte und andererseits des Knotenstroms und der Knotenspannung sowie des Wanderwellenmodells für diesen Leitungsabschnitt eine zweiseitige Fehlerortbestimmung durchgeführt wird.

Auf diese Weise kann die komplexe verzweigte Struktur quasi auf die Betrachtung mehrerer Leitungsabschnitte mit jeweils zwei Enden reduziert werden. Da an den Knotenpunkten üblicherweise keine Messwerte erfasst werden und die Nachrüstung von entsprechenden Messgeräten, die in der Lage sind, transiente Verläufe zu erfassen, mit hohen Kosten verbunden wäre, ist bevorzugt vorgesehen, dass Strom und Spannung am Knotenpunkt anhand der vorhandenen Messungen an den Leitungsenden rechnerisch bestimmt werden. Damit können die für die zweiseitige Fehlerortung zunächst fehlenden transienten Verläufe von Strom und Spannung am Knotenpunkt ergänzt und nachfolgend gemeinsam mit den vorliegenden Messwerten zur Ermittlung des Fehlerortes herangezogen werden. Durch die Verwendung der transienten Verläufe nach dem Wanderwellen-Prinzip können zudem Probleme mit der Bildung von Strom- und Spannungszeigern der Grundschwingung ausgeschlossen werden, die insbesondere in verzweigten Strukturen dadurch entstehen, dass nicht alle Leitungsabschnitte komplett synchron abgeschaltet werden und daher Übergangseffekte die Messung der Signale in der Grundschwingung verfälschen.

Erfindungsgemäß ist zudem vorgesehen, dass bei der Bestimmung des Knotenstroms und der Knotenspannung die Strom- und Spannungswerte desjenigen Leitungsendes ausgeschlossen werden, das den jeweils zur Fehlerortbestimmung betrachteten Leitungsabschnitt begrenzt.

Hierdurch kann erreicht werden, dass für eine Fehlerortung solche Messwerte ausgeschlossen werden, die eine Fehlerortbestimmung verfälschen würden, da das Wanderwellenmodell in diesem Fall ein falsches Ergebnis für Knotenspannung und Knotenstrom liefern würde.

Gemäß einer vorteilhaften Ausführungsform kann vorgesehen sein, dass die Fehlerortbestimmung anhand einer Zeitdifferenz durchgeführt wird, mit der eine Strom- oder eine Spannungsflanke einer Wanderwelle an den beiden Enden des jeweiligen Leitungsabschnitts eintrifft.

Auf diese Weise kann die zweiseitige Fehlerortung mit den gemessenen bzw. berechneten transienten Verläufen in einfacher Weise durchgeführt werden.

Bei dem erfindungsgemäßen Verfahren wird bei einem vorliegenden Fehler eine Fehlerortung für jeden Leitungsabschnitt durchgeführt, da anfänglich nicht bekannt ist, auf welchem Leitungsabschnitt der Fehler konkret vorliegt. Da üblicherweise nur ein Leitungsabschnitt tatsächlich von einem Fehler betroffen sein wird, gilt es, den korrekten Leitungsabschnitt und damit den korrekten Fehlerort auszuwählen. Daher ist gemäß einer weiteren vorteilhaften Ausführungsform des erfindungsgemäßen Verfahrens vorgesehen, dass mittels der Fehlerortbestimmung für die einzelnen Leitungsabschnitte jeweils mögliche Fehlerorte ermittelt werden, und derjenige mögliche Fehlerort als tatsächlicher Fehlerort ausgewählt wird, bei dem die Fehlerortbestimmung im Vergleich zu den anderen möglichen Fehlerorten am deutlichsten auf einen an einem bestimmten Ort vorliegenden Fehler hinweist.

Prinzipiell wird mit der für jeden Leitungsabschnitt der Leitung durchgeführten Fehlerortbestimmung nämlich ein möglicher Fehlerort pro Leitungsabschnitt bestimmt. Da der Fehler üblicherweise tatsächlich jedoch an lediglich einem Ort auf der Leitung vorliegt, muss aus der Vielzahl an möglichen Fehlerorten auf den tatsächlichen Fehlerort geschlossen werden. Dies erfolgt vorliegend durch einen Vergleich der Ergebnisse der Fehlerortbestimmung der einzelnen Leitungsabschnitte und Auswahl des eindeutigsten Ergebnisses zur Angabe des tatsächlichen Fehlerortes. Somit wird der korrekte (tatsächliche) Fehlerort folglich durch einen Vergleich der Ergebnisse der jeweiligen Fehlerortbestimmung für die einzelnen Leitungsabschnitte ermittelt, indem die Ergebnisse für die einzelnen Leitungsabschnitte miteinander verglichen werden. Das eindeutigste Ergebnis wird als Hinweis auf den tatsächlichen Fehlerort angesehen.

In diesem Zusammenhang wird es zudem als vorteilhaft angesehen, wenn zur Fehlerortbestimmung für jeden Leitungsabschnitt geprüft wird, ob es auf dessen Länge einen Ort gibt, an dem von beiden Enden des Leitungsabschnitts berechnete zeitliche Profile einer an diesem Ort vorliegenden Spannung und/oder eines an diesem Ort vorliegenden Stromes übereinstimmen, und ein solcher Ort als möglicher Fehlerort für den jeweiligen Leitungsabschnitt verwendet wird.

Hierbei wird somit eine Methode zur zweiseitigen Fehlerortung eingesetzt, wie sie auch in der eingangs erwähnten EP 3 223 026 A1 beschrieben ist. Der Vorteil dieser Methode besteht darin, dass nicht nur einzelne Flanken der transienten Ströme und Spannungen, sondern längere zeitliche Verläufe (Profile) zur Fehlerortung herangezogen werden. Durch einen Mustervergleich kann erkannt werden, ob die Verläufe beider Leitungsenden für den gewählten Fehlerort übereinstimmen.

In diesem Zusammenhang kann beispielsweise vorgesehen sein, dass die Ermittlung des möglichen Fehlerortes mittels eines Optimierungsverfahrens erfolgt, wobei der Fehlerort als Optimierungsgröße einer Zielfunktion des Optimierungsverfahrens verwendet wird.

Hierdurch kann mit vertretbarem Rechenaufwand durch mathematische Optimierung (z.B. eine Minimierung oder eine Maximierung der Zielfunktion) der tatsächliche Fehlerort ermittelt werden. Dabei kann das Optimierungsverfahren beispielsweise ein iteratives Optimierungsverfahren sein.

Konkret kann in diesem Zusammenhang beispielsweise vorgesehen sein, dass eine Minimierung der Zielfunktion in Form einer Differenz der von den jeweiligen Enden des jeweiligen Leitungsabschnitts berechneten zeitlichen Profile durchgeführt wird und als möglicher Fehlerort auf dem jeweiligen Leitungsabschnitt derjenige Ort angesehen wird, an dem die Zielfunktion ein Minimum einnimmt.

Mit dieser Vorgehensweise kann die bestmögliche Überdeckung der Profile der Wanderwellen der beiden Leitungsenden gefunden werden, um daraus auf die Zeitdifferenz des Eintreffens der Wanderwellen zu schließen.

Alternativ kann auch vorgesehen sein, dass eine Maximierung der Zielfunktion in Form eines Produktes des zeitlichen Profils von dem einen Ende des jeweiligen Leitungsabschnitts sowie des konjugiert komplexen Verlaufs des zeitlichen Profils von dem anderen Ende des jeweiligen Leitungsabschnitts durchgeführt wird und als möglicher Fehlerort auf dem jeweiligen Leitungsabschnitt derjenige Ort angesehen wird, an dem die Zielfunktion ein Maximum einnimmt.

Die Zielfunktion beschreibt im letztgenannten Fall ein sogenanntes Kreuzleistungsspektrum, das auf die beschriebene Art und Weise im Frequenzbereich gebildet wird. Im Zeitbereich entspricht die Zielfunktion einer Kreuzkorrelation der von beiden Leitungsenden bestimmten Profile.

Darüber hinaus sind auch weitere Zielfunktionen denkbar, mit denen der fiktive Fehlerort ermittelt werden kann, für den die beiden Verläufe der Fehlerspannungswerte am stärksten übereinstimmen.

In diesem Zusammenhang kann gemäß einer weiteren vorteilhaften Ausführungsform des erfindungsgemäßen Verfahrens vorgesehen sein, dass die Verläufe der jeweiligen Zielfunktion aller Leitungsabschnitte miteinander verglichen werden, und derjenige mögliche Fehlerort als tatsächlicher Fehlerort ausgewählt wird, dessen Zielfunktion im Vergleich zu den Zielfunktionen der anderen möglichen Fehlerorte ein globales Extremum aufweist.

Auf diese Weise kann besonders einfach eine Auswahl aus den möglichen Fehlerorten zur Angabe des tatsächlichen Fehlerortes erfolgen, da als Kriterium zur Auswahl lediglich das globale Minimum oder Maximum der Verläufe der Zielfunktionen heranzuziehen ist. Als globales Extremum wird der größte Maximalwert oder kleinste Minimalwert über alle betrachteten Zielfunktionen angesehen.

Eine weitere vorteilhafte Ausführungsform des erfindungsgemäßen Verfahrens sieht zudem vor, dass bei einer Leitung mit mehr als einem Knotenpunkt die transienten Verläufe des jeweiligen Knotenstroms und der jeweiligen Knotenspannung für jeden Knotenpunkt bestimmt werden, und auf zwischen zwei Knotenpunkten liegenden Leitungsabschnitten eine zweiseitige Fehlerortbestimmung unter Verwendung der für die jeweiligen Knotenpunkte bestimmten transienten Verläufe des Knotenstroms und der Knotenspannung durchgeführt wird.

Somit werden zunächst die Knotenströme und -spannungen für alle Knotenpunkte aus den gemessenen Strömen und Spannungen ermittelt. Daraufhin kann für diejenigen Leitungsabschnitte, die kein Ende aufweisen, an dem gemessene Werte vorliegen, eine Fehlerortbestimmung anhand der für die Knotenpunkte bestimmten Knotenströme und -spannungen durchgeführt werden.

Gemäß einer weiteren vorteilhaften Ausführungsform des erfindungsgemäßen Verfahrens kann vorgesehen sein, dass der Knotenstrom und die Knotenspannung bei einem der Leitungsabschnitte, der teilweise als Freileitung und teilweise als unterirdisches Kabel ausgebildet ist, anhand eines Wanderwellenmodells bestimmt werden, das Leitungsparameter sowohl der Freileitung als auch des unterirdischen Kabels berücksichtigt.

Auf diese Weise kann durch Verwendung passender Leitungsparameter, die einerseits für die Freileitung und andererseits für das unterirdische Kabel gültig sind, auch für einen solchen gemischten Leitungsabschnitt ein Wanderwellenmodell angesetzt werden. Dazu kann beispielsweise der fragliche Leitungsabschnitt in mehrere (mindestens zwei) Segmente unterteilt werden, und die Parameter können pro Segment ermittelt und durch eine Verkettung zum Gesamtmodell der Leitung zusammengeführt werden.

Eine weitere vorteilhafte Ausführungsform des erfindungsgemäßen Verfahrens sieht vor, dass die an den Leitungsenden gemessenen Strom- und Spannungswerte einer Filterung unterzogen werden, wobei gefilterte Strom- und Spannungswerte gebildet werden, die einen ausgewählten Frequenzbereich der gemessenen Strom- und Spannungswerte angeben.

Hierdurch können in vorteilhafter Weise nur die für die Wanderwellen relevanten Signalanteile ermittelt und zur Fehlerortung verwendet werden. Bei dieser Ausführungsform werden nämlich entsprechend der Filterauslegung nur ausgewählte Signalanteile der Strom- und Spannungsmesswerte in einem geeigneten Frequenzbereich zur Fehlerortung herangezogen.

In diesem Zusammenhang kann konkret vorgesehen sein, dass der ausgewählte Frequenzbereich hochfrequente transiente Anteile oder bandbegrenzte transiente Anteile der gemessenen Strom- und Spannungswerte umfasst.

Außerdem kann in diesem Zusammenhang vorgesehen sein, dass die Filtercharakteristik des zur Filterung der Strom- und Spannungswerte benutzten Filters solche Frequenzbereiche bedämpft, in denen zur Messung der Strom- und Spannungsmesswerte verwendete Strom- bzw. Spannungswandler Messfehler aufweisen.

Auf diese Weise können Messfehler, die auf die Strom- bzw. Spannungswandler zurückgehen, besonders effektiv unterdrückt werden.

Schließlich kann gemäß einer weiteren vorteilhaften Ausführungsform des erfindungsgemäßen Verfahrens auch vorgesehen sein, dass die Strom- und Spannungswerte an den Leitungsenden durch Abtastung von analogen Strom- und Spannungssignalen mit einer Abtastfrequenz oberhalb der Grundfrequenz der Signale, vorzugsweise mit einer Abtastrate zwischen 8kHz und 64kHz, erfasst werden.

Auf diese Weise kann sichergestellt werden, dass die hochfrequenten transienten Signale korrekt erfasst und weiterverarbeitet werden können. Dabei sind höhere Abtastraten prinzipiell vorzuziehen.

Die oben genannte Aufgabe wird auch durch eine Einrichtung zum Ermitteln des Fehlerortes eines Fehlers auf einer Leitung eines elektrischen Energieversorgungsnetzes gelöst, mit einer Messanordnung, die dazu eingerichtet ist, transiente Verläufe von Strom- und Spanungswerten an einem Leitungsende der Leitung zu messen, und einer Recheneinrichtung, die dazu eingerichtet ist, unter Verwendung der von der Messanordnung gemessenen transienten Verläufe der Strom- und Spannungswerte nach dem Auftreten eines Fehlers auf der Leitung dessen Fehlerort zu bestimmen.

Erfindungsgemäß ist vorgesehen, dass die Leitung einen ersten Leitungsabschnitt mit einem ersten Leitungsende, einen zweiten Leitungsabschnitt mit einem zweiten Leitungsende und zumindest einen weiteren Leitungsabschnitt mit einem weiteren Leitungsende sowie zumindest einen Knotenpunkt aufweist, an dem sich mehr als zwei der Leitungsabschnitte treffen, die Recheneinrichtung dazu eingerichtet ist, transiente Verläufe eines Knotenstroms und einer Knotenspannung an dem zumindest einen Knotenpunkt unter Verwendung zumindest der Strom- und Spannungswerte eines Leitungsendes sowie eines Wanderwellenmodells für den jeweiligen Leitungsabschnitt zu bestimmen, und die Recheneinrichtung dazu eingerichtet ist, für jeden Leitungsabschnitt unter Verwendung einerseits des transienten Verlaufs der an dessen Leitungsende gemessenen Strom- und Spannungswerte und andererseits des Knotenstroms und der Knotenspannung sowie des Wanderwellenmodells für diesen Leitungsabschnitt eine zweiseitige Fehlerortbestimmung durchzuführen, wobei bei der Bestimmung des Knotenstroms und der Knotenspannung die Strom- und Spannungswerte desjenigen Leitungsendes ausgeschlossen werden, das den jeweils zur Fehlerortbestimmung betrachteten Leitungsabschnitt begrenzt.

Hinsichtlich der erfindungsgemäßen Einrichtung gelten alle zu dem erfindungsgemäßen Verfahren voranstehend und nachfolgend gemachten Ausführungen und umgekehrt in entsprechender Weise, insbesondere ist die erfindungsgemäße Einrichtung zur Durchführung des erfindungsgemäßen Verfahrens in jeder beliebigen Ausführungsform oder einer Kombination beliebiger Ausführungsformen eingerichtet. Auch hinsichtlich der Vorteile der erfindungsgemäßen Einrichtung wird auf die zu dem erfindungsgemäßen Verfahren beschriebenen Vorteile verwiesen.

Außerdem wird die oben genannte Aufgabe auch gelöst durch ein System zum Ermitteln des Fehlerortes eines Fehlers auf einer Leitung eines elektrischen Energieversorgungsnetzes, mit mehreren Messeinrichtungen, die dazu eingerichtet sind, transiente Verläufe von Strom- und Spanungswerten an den Leitungsenden der Leitung zu messen, und mindestens einer Recheneinrichtung, die dazu eingerichtet ist, unter Verwendung der transienten Verläufe der Strom- und Spannungswerte nach dem Auftreten eines Fehlers auf der Leitung (10) dessen Fehlerort (F) zu bestimmen.

Erfindungsgemäß ist vorgesehen, dass die Leitung einen ersten Leitungsabschnitt mit einem ersten Leitungsende, einen zweiten Leitungsabschnitt mit einem zweiten Leitungsende und zumindest einen weiteren Leitungsabschnitt mit einem weiteren Leitungsende sowie zumindest einen Knotenpunkt aufweist, an dem sich mehr als zwei der Leitungsabschnitte treffen, die Recheneinrichtung dazu eingerichtet ist, transiente Verläufe eines Knotenstroms und einer Knotenspannung an dem zumindest einen Knotenpunkt unter Verwendung zumindest der Strom- und Spannungswerte eines Leitungsendes sowie eines Wanderwellenmodells für den jeweiligen Leitungsabschnitt zu bestimmen, und die Recheneinrichtung dazu eingerichtet ist, für jeden Leitungsabschnitt unter Verwendung einerseits des transienten Verlaufs der an dessen Leitungsende gemessenen Strom- und Spannungswerte und andererseits des Knotenstroms und der Knotenspannung sowie des Wanderwellenmodells für diesen Leitungsabschnitt eine zweiseitige Fehlerortbestimmung durchzuführen, wobei bei der Bestimmung des Knotenstroms und der Knotenspannung die Strom- und Spannungswerte desjenigen Leitungsendes ausgeschlossen werden, das den jeweils zur Fehlerortbestimmung betrachteten Leitungsabschnitt begrenzt.

Hinsichtlich des erfindungsgemäßen Systems gelten alle zu dem erfindungsgemäßen Verfahren und der erfindungsgemäßen Einrichtung voranstehend und nachfolgend gemachten Ausführungen und umgekehrt in entsprechender Weise, insbesondere ist das erfindungsgemäße System zur Durchführung des erfindungsgemäßen Verfahrens in jeder beliebigen Ausführungsform oder einer Kombination beliebiger Ausführungsformen eingerichtet. Auch hinsichtlich der Vorteile des erfindungsgemäßen Systems wird auf die zu dem erfindungsgemäßen Verfahren beschriebenen Vorteile verwiesen.

Die Erfindung wird nachfolgend anhand eines Ausführungsbeispiels näher erläutert. Die spezifische Ausgestaltung des Ausführungsbeispiels ist für die allgemeine Ausgestaltung des erfindungsgemäßen Verfahrens und der erfindungsgemäßen Einrichtung in keiner Weise einschränkend zu verstehen; vielmehr können einzelne Ausgestaltungsmerkmale des Ausführungsbeispiels in beliebiger Weise frei untereinander und mit den voranstehend beschriebenen Merkmalen kombiniert werden.

Hierzu zeigen

Figur 1 eine schematische Ansicht einer Leitung eines elektrischen Energieversorgungsnetzes mit drei an einem Knotenpunkt zusammentreffenden Leitungsabschnitten;

Figur 2 eine schematische Ansicht einer Leitung eines elektrischen Energieversorgungsnetzes mit mehreren Knotenpunkten und mehreren Leitungsabschnitten;

Figur 3 ein Ablaufschema zum Ermitteln eines Ausführungsbeispiels eines Verfahrens zum Ermitteln eines Fehlerortes auf einer Leitung;

Figur 4 ein Vierpol als PI-Glied zur Erläuterung der Ermittlung von transienten Verläufen von Strom und Spannung an einem Knotenpunkt;

Figur 5 eine schematische Ansicht eines Leitungsabschnittes mit einer Einrichtung zur Ermittlung eines Fehlerortes;

Figur 6 ein schematisches Ablaufschema zur Erläuterung der Vorgehensweise bei einer zweiseitigen Fehlerortbestimmung;

Figur 7 ein Verlauf einer Zielfunktion zur Erläuterung eines Fehlerortes bei einer Leitung mit drei Leitungsenden;

Figur 8 ein vereinfachtes Leitungsmodell einer Leitung mit gemischten Leitungssegmenten;

Figur 9 ein Vierpol als PI-Glied zur Modellierung einer Leitung mit gemischten Leitungssegmenten; und

Figur 10 ein Verlauf einer Zielfunktion zur Erläuterung eines Fehlerortes bei einer Leitung mit gemischten Leitungssegmenten.

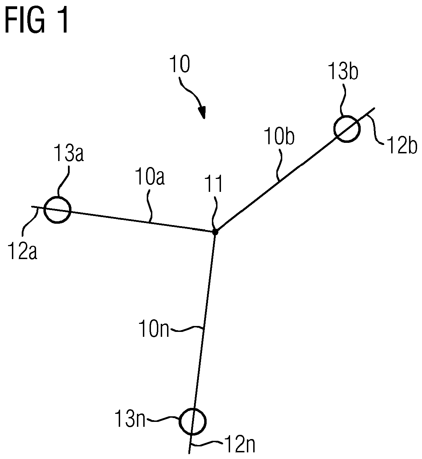

Figur 1 zeigt eine schematische Ansicht einer Leitung 10 eines verzweigt aufgebauten elektrischen Energieversorgungsnetzes. Obwohl in Figur 1 eine einphasige Leitung dargestellt ist, kann das Energieversorgungsnetz auch mehrphasig, insbesondere dreiphasig, ausgebildet sein. Die Leitung 10 umfasst drei Leitungsabschnitte 10a, 10b, 10n, die sich an einem gemeinsamen Knotenpunkt 11 treffen. An ihren dem Knotenpunkt abgewandten Leitungsenden 12a, 12b, 12n sind Messstellen 13a, 13b, 13n vorgesehen, an denen mit geeigneten Sensoren Ströme und Spannungen erfasst und an (in Figur 1 nicht gezeigte) Einrichtungen zur Ermittlung eines Fehlerortes auf der Leitung weitergeleitet werden. Bei den Einrichtungen kann es sich zum Beispiel um IEDs (Intelligent Electronic Devices) in Form von elektrischen Schutzgeräten oder von Fehlerschreibern handeln. Außerdem ist es möglich, dass die an den Leitungsenden aufgenommenen Ströme und Spannungen zu einer zentralen Einrichtung zur Ermittlung des Fehlerortes weitergegeben werden. Dabei kann es sich um einen oder mehrere Recheneinrichtungen oder um eine Cloud-Plattform (z.B. die Mindsphere Cloud der Siemens AG) handeln.

In Figur 1 ist ein relativ einfaches Beispiel einer verzweigten Leitung, nämlich eine sogenannte "Dreibein-Topologie" gezeigt. Diese kann als Grundbaustein verzweigter Netztopologien angesehen werden.

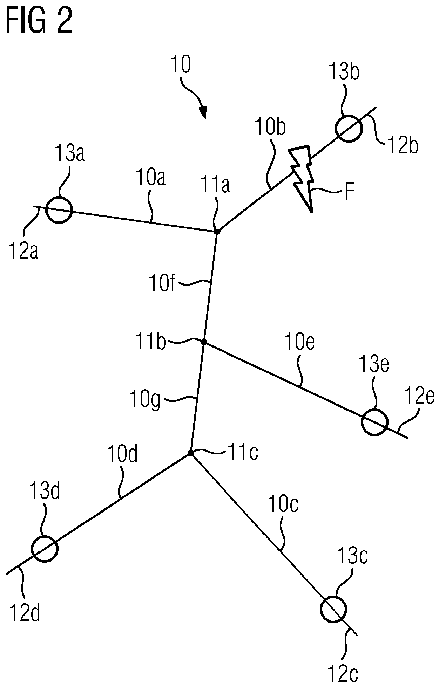

Ein komplexeres Beispiel einer verzweigten Leitung 10 ist in Figur 2 gezeigt. Die Leitung 10 der Figur 2 umfasst fünf Leitungsenden 12a-e und drei Knotenpunkte 11a-c und ist in 7 Leitungsabschnitte 10a-g unterteilt.

Solche verzweigten Netztopologien werden in letzter Zeit vermehrt eingesetzt, um beispielsweise dem Ausbau von Verteilnetzen zur Anbindung dezentraler Energieerzeuger (PV-Anlagen, Windräder, Blockheizkraftwerke etc.) zu begegnen. Während jedoch bei Leitungen mit zwei Leitungsenden eine Fehlererkennung und eine Fehlerortbestimmung unter Anwendung üblicher einseitiger oder zweiseitiger Fehlerortungsmethoden relativ einfach durchgeführt werden kann, ist die Erkennung und Ortung eines Fehlers in einer verzweigten Topologie mit größeren Schwierigkeiten verbunden. Nachfolgend wird ein Verfahren vorgestellt, mit dem auch in solchen verzweigten Netzstrukturen eine genaue Fehlerortbestimmung durchgeführt werden kann.

Dazu wird die Netztopologie gemäß Figur 2 betrachtet und angenommen, dass auf dem Leitungsabschnitt 10b ein Fehler F vorliegt. Die Fehlerortbestimmung erfolgt nach dem Prinzip der Wanderwellen, bei dem transiente Verläufe in den gemessenen Strömen und Spannungen betrachtet werden. Die Transienten-Fehlerortbestimmung besitzt mehrere Vorteile. Einer dieser Vorteile besteht darin, dass die Notwendigkeit der Zeigerberechnung für die Nominalfrequenz entfällt. Besonders bei sehr kurzen Abschaltzeiten eines Netzfehlers liefert die Transienten-Fehlerortung verlässlichere Ergebnisse als zeigerbasierte Methoden. Die Fehlerortbestimmung unter Verwendung von Transienten liefert außerdem aufgrund der Analyse eines breiteren Frequenzspektrums ein zuverlässigeres Ergebnis. Besonders bei gelöscht oder isoliert betriebenen Netzen bietet die Transienten-Fehlerortung eine hohe Zuverlässigkeit der ermittelten Ergebnisse. Außerdem kann die Transienten-Fehlerortung auch in vernetzten Topologien (sogenannte "Dreibein-Netztopologien") eingesetzt werden. Die in Figur 2 dargestellte Topologie, kann als eine geschachtelte Dreibein-Netztopologie angesehen werden. In dem gezeigten Beispiel wird angenommen, dass an den fünf Leitungsenden 12a-e Ströme und Spannungen gemessen werden können. Für die Messung sind Einrichtungen zu verwenden, die eine Signalabtastung mit einer vergleichsweise hohen Abtastrate (z.B. 8-64 kHz) vornehmen können. Der Grund dafür ist die Notwendigkeit der Aufzeichnung von Transienten, also hochfrequenten Signalanteilen, die mit herkömmlichen Messeinrichtungen mit vergleichsweise geringen Abtastraten nicht aufgenommen werden können. Die Erfassung kann beispielsweise mit einem Fault-Recorder oder einem Schutzgerät erfolgen. Bei dem Beispiel der Figur 2 wird zudem angenommen, dass an den drei innenliegenden Knotenpunkte 11a-c keine Messeinrichtungen vorhanden sind, so dass dort keine Ströme und Spannungen messtechnisch erfasst werden können. Die Ströme und Spannungen an den Knotenpunkten 11a-c muss daher auf Grundlage der an den Leitungsenden 12a-e erfassten Strom- und Spannungsmesswerte bestimmt werden. Dies wird später im Detail erläutert.

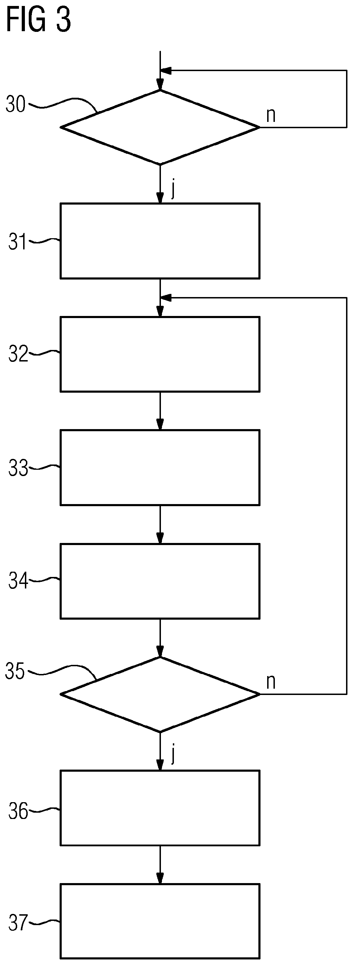

Prinzipiell werden zur Bestimmung des Fehlerortes auf einer verzweigten Leitung die in Figur 3 schematisch aufgezeigten Schritte durchgeführt. In einem ersten Schritt 30 wird zunächst kontinuierlich überwacht, ob ein Fehler auf der Leitung 10 aufgetreten ist. Eine solche Erkennung kann unter Verwendung allgemein bekannter Schutzalgorithmen erfolgen, die auf Basis von Messwerten eine Entscheidung darüber treffen, ob sich die Leitung in einem fehlerbehafteten Zustand befindet. Beispielsweise kann hierfür ein Distanzschutzalgorithmus, ein Differentialschutzalgorithmus, ein Überstromschutz-Algorithmus oder ein anderer Schutzalgorithmus eingesetzt werden. Sofern in Schritt 30 kein Fehler erkannt worden ist, wird die kontinuierliche Überwachung fortgesetzt. Sofern hingegen ein Fehler erkannt worden ist, werden in einem nächsten Schritt 31 Ströme und Spannungen an allen verfügbaren Messstellen (im vorliegenden Beispiel an den Leitungsenden 12a-e) erfasst und daraus transiente zeitliche Verläufe von Strom- und Spannungswerten gebildet. Als Ergebnis des Schrittes 31 liegt für jede Messstelle ein transienter Verlauf von Strom und Spannung für einen vorgegebenen Zeitraum ab Fehlereintritt vor.

In einem folgenden Schritt 32 beginnt die eigentliche Fehlerortbestimmung. Dazu wird zunächst einer der Leitungsabschnitte 12a-e ausgewählt, für den ein möglicher Fehlerort bestimmt wird. Sofern der Fehlerort bereits auf einen oder mehrere Leitungsabschnitte eingegrenzt werden kann, beispielsweise aufgrund der Auswertung weiterer Messungen, wie z.B. den Auswertungen sogenannter Fehleranzeiger, wird in Schritt 32 ein Leitungsabschnitt aus dieser eingegrenzten Menge von Leitungsabschnitten ausgewählt. Kann noch keine Eingrenzung erfolgen, wird in Schritt 32 einer von allen vorhandenen Leitungsabschnitten ausgewählt.

Sofern nicht an beiden Enden des ausgewählten Leitungsabschnitts gemessene transiente Strom- und Spannungswerte vorliegen, werden in einem folgenden Schritt 33 die fehlenden transienten Verläufe anhand der vorhandenen gemessenen Verläufe bestimmt. Dabei werden jeweils Messwerte, die am anderen Ende des als fehlerhaft angenommenen ausgewählten Leitungsabschnitts erfasst worden sind, ausgenommen.

Üblicherweise werden wie im vorliegenden Beispiel Messwerte an den Leitungsenden vorliegen, an den Knotenpunkten hingegen nicht. Zur Ermittlung der fehlenden transienten Verläufe der Knotenströme und -spannungen werden einerseits die gemessenen Verläufe und andererseits Wanderwellenmodelle der einzelnen Leitungsabschnitte verwendet. Solche Wanderwellenmodelle beschreiben die Ausbreitung von Strom und Spanungssignalen entlang eines elektrischen Leiters. Die genaue Vorgehensweise bei der Bestimmung der transienten Verläufe an den Enden der Leitungsabschnitte, an denen keine Messungen vorgenommen werden, wird später eingehender erläutert.

In einem weiteren Schritt 34 wird für den ausgewählten Leitungsabschnitt eine zweiseitige Fehlerortbestimmung durchgeführt. Dazu wird in herkömmlicher Weise eine zweiseitige Wanderwellen-Fehlerortbestimmung durchgeführt. Ein Beispiel einer solchen Wanderwellen-Fehlerortbestimmung, wie es auch im Detail in der EP 3 193 420 A1 beschrieben ist, wird später zusammenfassend erläutert. Andere verwendbare Beispiele zur Ermittlung des Fehlerortes unter Verwendung der Wanderwellenmethode sind aus der EP 3 223 026 A1 sowie der US 8,655,609 B2 beschrieben.

Als Ergebnis der zweiseitigen Fehlerortbestimmung in Schritt 34 liegt ein möglicher Fehlerort vor.

In einem nächsten Schritt 35 wird geprüft, ob für alle Leitungsabschnitte, auf denen der Fehler vorliegen könnte, bereits eine Fehlerortbestimmung durchgeführt worden ist. Ist dies nicht der Fall, so wird mit Schritt 32 der nächste Leitungsabschnitt ausgewählt. Das oben anhand der Schritte 32 bis 34 beschriebene Verfahren wird nachfolgend so lange durchgeführt, bis die Prüfung in Schritt 35 ergibt, dass für alle Leitungsabschnitte, auf denen der Fehler vorliegen kann, ein möglicher Fehlerort bestimmt worden ist.

Als Ergebnis liegen nach Schritt 35 somit mögliche Fehlerorte für alle potentiell fehlerbehafteten Leitungsabschnitte vor. Ein solcher möglicher Fehlerort stimmt jedoch nur dann mit dem tatsächlichen Fehlerort überein, wenn der ausgewählte Leitungsabschnitt tatsächlich fehlerbehaftet war. Der Betreiber des Energieversorgungsnetzes, zu dem die verzweigte Leitung 10 gehört, hat nunmehr die Möglichkeit, alle angegebenen möglichen Fehlerorte in Augenschein zu nehmen. Damit ist der Aufwand zur Ermittlung des tatsächlichen Fehlerortes bereits deutlich reduziert, da nicht mehr die gesamte Länge der Leitungsabschnitte betrachtet werden muss.

Es ist jedoch optional auch möglich, den tatsächlichen Fehlerort aus der Menge der angegebenen möglichen Fehlerorte automatisch zu ermitteln. Dazu werden in einem weiteren Schritt 36 die in Schritt 34 jeweils gebildeten Ergebnisse zur Ermittlung der möglichen Fehlerorte miteinander verglichen. Insbesondere werden Zielfunktionen, die zur Ermittlung des jeweiligen möglichen Fehlerortes verwendet worden sind, dahingehend miteinander verglichen, welche das am eindeutigsten auf einen tatsächlich vorliegenden Fehler hinweisende Ergebnis ist. Beispielsweise kann in diesem Zusammenhang bei der Minimierung einer Zielfunktion das globale Minimum der verwendeten Zielfunktionen als Hinweis auf den tatsächlichen Fehlerort gewertet werden.

Schließlich wird in Schritt 37 der tatsächliche Fehlerort ausgegeben. Die Ausgabe kann beispielsweise den fehlerbehafteten Leitungsabschnitt und eine Angabe der Entfernung des Fehlerortes von einer Referenzstelle, z.B. der Messstelle am Leitungsende (in Kilometern oder Prozent der Leitungsabschnittslänge) angeben.

Nachfolgend werden einige der im Zusammenhang mit Figur 3 genannten Schritte im Einzelnen näher erläutert. Hierzu wird erneut die verzweigte Leitung von Figur 2 betrachtet. Zunächst soll erläutert werden, wie die transienten Verläufe von Strom und Spannung für die Knotenpunkte 11a-c der Leitung 10 berechnet werden können. Um eine Fehlerortung für die komplette Leitung 10 durchführen zu können, müssen nämlich auch die Ströme und Spannungen an den nicht messtechnisch eingebundenen Knotenpunkten 11a-c ermittelt werden, weil zu Beginn der Fehlerortbestimmung nicht sicher ist, wo der Fehler tatsächlich liegt. Dafür muss jeder Leitungsabschnitt als potentiell fehlerbehaftet angenommen werden. Folglich müssen Fehlerortbestimmungen für die sieben vorhandenen Leitungsabschnitte 10a-g durchgeführt werden. Die Fehlerortbestimmung erfolgt für jeden Leitungsabschnitt nach dem Wanderwellenprinzip, wie es beispielsweise in der EP 3 193 420 A1 beschreiben worden ist. Dafür sind jeweils an beiden Enden eines Leitungsabschnittes transiente Verläufe von Strom und Spannung erforderlich. Im Fall der Figur 2 existiert kein Leitungsabschnitt, für den die transienten Verläufe von Strom und Spannung an seinen beiden Enden durch Messung ermittelt werden können, da an den Knotenpunkte 11a-c keine Messgeräte installiert sind. Daher müssen die transienten Verläufe für diese Knotenpunkte 11a-c berechnet werden. Hierfür werden Wanderwellenmodelle der jeweiligen Leitungsabschnitte erstellt. Unter der Annahme, dass die Parameter der Leitungen, wie Wellenimpedanz, Propagationskonstante, bekannt sind, werden die Wanderwellenmodelle nach unter Anwendung der Telegraphen-Gleichungen als sogenannte PI-Glieder für ein breites Frequenz-Spektrum erstellt. Dafür müssen folgende Gleichungen verwendet werden:

$$U_p(l, j\omega) = U_q(j\omega) \cosh \gamma (j\omega)l - Z_c(j\omega) \cdot I_q(j\omega) \sinh \gamma (j\omega)l$$

$$I_p(l, j\omega) = -U_q(j\omega) \frac{1}{Z_c(j\omega)} \sinh \gamma (j\omega)l - Z_c(j\omega) \cdot I_q(j\omega) \cosh \gamma (j\omega)l$$

Hierbei stehen $U_p$ und $I_p$ für die gesuchten Verläufe von Spannung und Strom am jeweils betrachteten Knotenpunkt und $U_q$ und $I_q$ für die durch Messung bestimmten Spannungen und Ströme am jeweiligen Leitungsende. Außerdem bedeuten γ die Propagationskonstante, Zc die Wellenimpedanz und l die Länge des jeweils modellierten Leitungsabschnittes.

Aus den obigen Gleichungen lässt sich ein sogenannter Vierpol aufbauen, über den sich unter Verwendung von Eingangssignalen - hier den Messgrößen $U_q$ und $I_q$ - die Ausgangssignale - hier die gesuchten Verläufe $U_p$ und $I_p$ - auf einem durch die Länge l angegebenen beliebigen Punkt eines elektrischen Leiters berechnen lassen. Als Gleichung formuliert, lässt sich ein Vierpol wie folgt darstellen:

$$\begin{bmatrix} \underline{U}_p \\ \underline{I}_p \end{bmatrix} = \begin{bmatrix} \cosh \gamma l & -\underline{Z}_c \sinh \gamma l \\ -\dfrac{\sinh \gamma l}{\underline{Z}_c} & \cosh \gamma l \end{bmatrix} \cdot \begin{bmatrix} \underline{U}_q \\ \underline{I}_q \end{bmatrix}$$

Diese Vierpole modellieren grundsätzlich eine einadrige Leitung mit dem Rückleiter. Um die Vierpole für gekoppelte dreiphasige Systeme verwenden zu können, sind diese zu entkoppeln, also in nicht gekoppelte einphasige Systeme zu transformieren. Dafür kann die sogenannte Clarke Transformation (auch $\alpha\beta0$-Modale-Transformation genannt) verwendet werden. In diesem Fall kann jede Modale-Komponente separat betrachtet werden. Diese Technik ist insbesondere bei in der Praxis auftretenden symmetrischen Systemen sehr effektiv. Im Falle von stark unsymmetrischen Systemen ist die sogenannte Eigenwerte-Analyse zu verwenden. Auch in diesem Fall wird das dreipolige System in drei separate einphasige Systeme zerlegt. Diese können dann unabhängig voneinander analysiert werden. Nachfolgend sollen symmetrische Systeme vorausgesetzt werden.

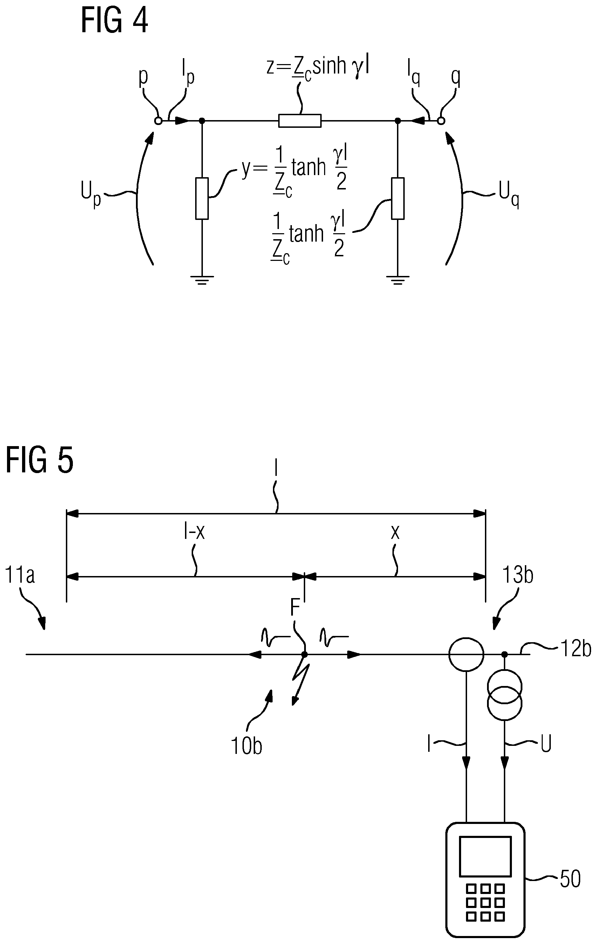

Um Vierpole in Dreibein-Netztopologien effektiv verwenden zu können, ist es vorteilhaft, die Leitungsabschnitte in Form von sogenannten PI-Gliedern zu modellieren. Ein solcher Vierpol in Form eines PI-Gliedes ist beispielhaft in Figur 4 gezeigt. Diese PI-Glieder sind von Frequenz abhängig und müssen für das relevante Frequenzspektrum berechnet werden. Pro betrachtende Frequenz gilt eine Beschreibung in Fourier-Raum. Um ein vollständiges Bild von Strom- und Spannungsverläufen in einem Netzsystem zu bekommen, sind PI-Glieder für jede der Modale-Komponenten ($\alpha\beta0$) einzusetzen. Diese Betrachtung kann vereinfacht werden, wenn nur die Fehlerortbestimmung durchgeführt wird. Dann ist es ausreichend, nur mit einer ausgewählten Modale-Komponente zu arbeiten. Die auszuwählende Komponente hängt von der Fehlerart ab.

Das Berechnungsverfahren soll nachfolgend an einem Beispiel näher erläutert werden. Hierzu wird angenommen, dass sich der Fehler auf dem Leitungsabschnitt 10b befindet. Zur Verfügung stehen Messungen von den Leitungsenden 12a-e. Für die Knotenpunkte 11a-c liegen hingegen keine Messungen vor. Um den fehlerhaften Leitungsabschnitt zu finden und den Fehlerort zu ermitteln, müssen auch die Knotenspannungen und Knotenströme am Knotenpunkt 11a bestimmt werden. Zu diesem Zweck wird das Knoten-Admittanz-Verfahren verwendet. Pro betrachtetem Leitungsabschnitt wird jeweils ein neues Modellsystem erstellt, bei dem der jeweils betrachtete Leitungsabschnitt eliminiert wird. Für die Berechnung der Knotenspannung und des Knotenstroms am Knotenpunkt 11a zum Zweck der Fehlerortbestimmung auf dem Leitungsabschnitt 10b wird demzufolge dieser Leitungsabschnitt 10b aus der Modellierung der verzweigten Leitung 10 herausgenommen. Zur Bestimmung des Stroms und der Spannung am Knotenpunkt 11a wird eine Knoten-Admittanz-Matrix in der Weise erstellt, dass die mit Messwerten gebundenen Parameter an der ersten Stelle der Matrix auftauchen (ströme und Spannungen der Leitungsenden 12a und 12c-e; das Leitungsende 12b wird für die Berechnung eliminiert). An eine weitere Stelle treten die Parameter der nicht messtechnisch erfassten Knotenpunkten 11b und 11c, die zur Fehlerortberechnung lediglich indirekt notwendig sind.

An die letzte Stelle treten die Parameter des Knotenpunktes 11a, für den der Strom und die Spannung bestimmt werden sollen. Für das betrachtete Beispiel ergibt sich hieraus die folgende Gleichung:

$$\begin{bmatrix} I_m \\ 0 \\ I_e \end{bmatrix} = \begin{bmatrix} y_{mm} & y_{mn} & y_{me} \\ y_{nm} & y_{nn} & y_{ne} \\ y_{em} & y_{en} & y_{ee} \end{bmatrix} \cdot \begin{bmatrix} U_m \\ U_n \\ U_e \end{bmatrix}$$

Dabei steht der Index m für die Parameter der durch Messung ermittelten Größen (Leitungsenden 12a, 12c-e), der Index n für die nicht durch Messung ermittelbaren Größen, die jedoch in die Fehlerortbestimmung des betrachteten Leitungsabschnitts nicht direkt eingehen (Knotenpunkte 11b, c), und der Index e für die zu ermittelnden Größen (Knotenpunkt 11a). Dabei umfasst die Matrix je nach Topologie entsprechend viele Elemente jeder Gruppe m, n.

Die Matrix der Admittanz-Parameter y ist bekannt und lässt sich aus der Netzstruktur sowie den PI-Gliedern aufstellen. Da vorliegend der zu ermittelnde Knotenstrom $I_e$ unbekannt ist, hingegen jedoch einige der Spannungen, nämlich die Spannungen $U_m$ bekannt sind, muss die Knoten-Admittanz-Matrix entsprechend umformuliert werden:

$$\begin{bmatrix} U_m \\ U_n \\ U_e \end{bmatrix} = \begin{bmatrix} z_{mm} & z_{mn} & z_{me} \\ z_{nm} & z_{nn} & z_{ne} \\ z_{em} & z_{en} & z_{ee} \end{bmatrix} \cdot \begin{bmatrix} I_m \\ 0 \\ I_e \end{bmatrix}$$

Knotenpunkte, an denen nicht gemessen wird und die kein Ende des auf den Fehler zu prüfenden Leitungsabschnitts darstellen, können aus der Betrachtung herausgenommen werden, wodurch sich die Impedanzmatrix entsprechend vereinfacht (angedeutet durch das Kreuz in der obigen Matrix). Hierdurch wird die Berechnung der gesuchten Parameter $U_e$ und $I_e$ am relevanten Knotenpunkt nicht beeinträchtigt.

Durch Inversion der Admittanz-Matrix entstehen folgende Gleichungen, in denen die Impedanzen z verwendet werden:

$$U_m = z_{mm}I_m + z_{me}I_e$$

$$U_e = z_{em}I_m + z_{ee}I_e$$

Nach Verwendung grundlegender Matrixoperationen kann festgestellt werden, dass die Berechnung der unbekannten Größen $U_e$, $I_e$ durch die folgenden beiden Gleichungen erfolgen kann:

$$I_e = (z_{me}^T z_{me})^{-1} z_{me}^T (U_m - z_{mm}I_m)$$

$$U_e = z_{em}I_m + z_{ee}I_e$$

Somit können unter Verwendung der an den Leitungsenden gemessenen Ströme und Spannungen die Knotenströme und Spannungen bestimmt werden (Schritt 33 in Figur 3). Zum Ende des Schrittes 33 liegen für jeden Leitungsabschnitt die jeweils benötigten transienten Verläufe von Strömen und Spannungen an seinen beiden Enden vor.

Für die Fehlerortbestimmung wird in Schritt 34 ein zweiseitiger Transienten-Fehlerortungsalgorithmus verwendet. Aus diesem Grund wird die verzweigte Leitung 10 auf mehrere Leitungsabschnitte mit jeweils zwei Enden reduziert. Damit ergibt sich für den jeweils betrachteten Leitungsabschnitt eine Situation, wie sie beispielhaft in Figur 5 für den Leitungsabschnitt 10b gezeigt ist.

Gemäß Figur 5 weist der Leitungsabschnitt 10b ein Leitungsende 12b auf, an dem eine Messstelle 13b vorgesehen ist. An der Messstelle 13b werden mittels einer Einrichtung 50 transiente Verläufe von Strömen und Spannungen erfasst. Die Einrichtung 50 kann z.B. ein Schutzgerät oder ein Fehlerschreiber (Fault Recorder) sein und mit einer ausreichend hohen Abtastrate (z.B. 8-64 kHz) Messwerte erfassen. Am anderen Ende des Leitungsabschnitts 10b liegt der Knotenpunkt 11a, für den keine Messungen vorliegen. Anstelle der gemessenen Werte werden die entsprechend der oben erläuterten Vorgehensweise berechneten Verläufe der Knotenspannung und der Knotenstroms verwendet. Beim Auftreten eines Fehlers an der Fehlerstelle F kann somit unter Verwendung der gemessenen Verläufe einerseits und der berechneten Verläufe andererseits eine zweiseitige Fehlerortung vorgenommen werden. Die zweiseitige Fehlerortung kann nach einem üblichen Wanderwellen-Fehlerortungsalgorithmus erfolgen. Nachfolgend wird eine Möglichkeit zur Fehlerortbestimmung kurz dargelegt.

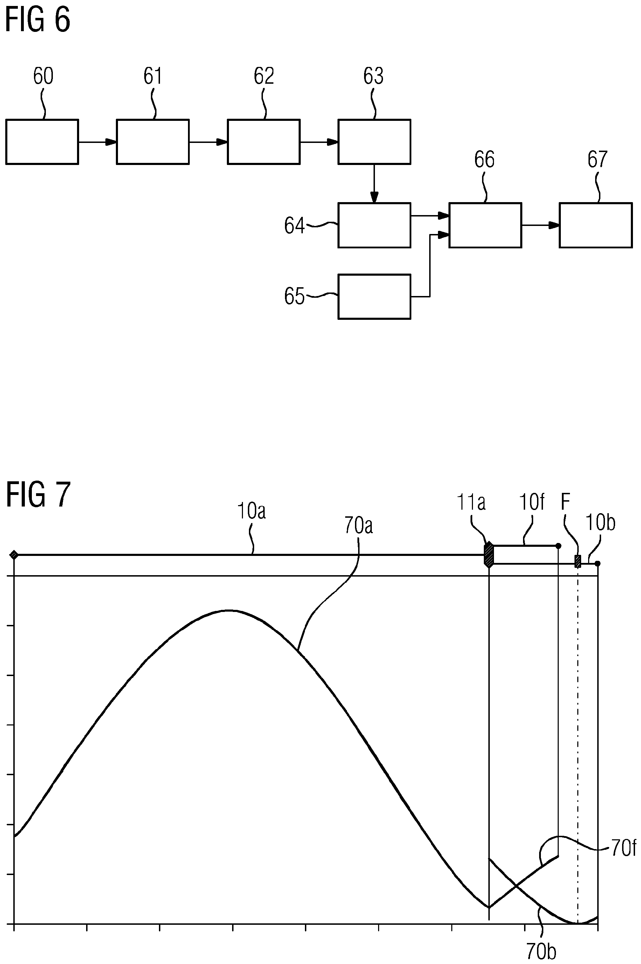

Hierzu zeigt Figur 6 ein schematisches Ablaufdiagramm eines Ausführungsbeispiels einer zweiseitigen Fehlerortbestimmung nach dem Wanderwellenprinzip. Dabei finden die Verfahrensschritte oberhalb der gestrichelten Linie in der Einrichtung 50 am Leitungsende 12b (vgl. Figur 5) statt.

Mit der Einrichtung 50 werden in Schritt 60 die lokalen Ströme und Spannungen gemessen und entsprechende Strom- und Spannungswerte erzeugt. Die Messwerte liegen als Abtastwerte der Strom- und Spannungssignale des Leitungsabschnitts 10b vor. Damit nur die hochfrequenten transienten Anteile (Wanderwellen) der jeweiligen Strom- bzw. Spannungsmesswerte erfasst werden, findet in Schritt 61 eine Filterung (z.B. durch einen Bandpassfilter) statt. Durch die Wahl der Eckfrequenzen z.B. des Bandpassfilters kann das Verfahren an die Eigenschaften der Wandler angepasst werden. Stellen diese Wandler nur eine mittlere Bandbreite, z.B. nur bis 10kHz, zur Verfügung, dann müssen die Filter die Bandbreite der Signale auf die Bandbreite der Wandler begrenzen. Je nach Phasenfehler der eingesetzten Wandler ist dann mit einer etwas geringeren Messgenauigkeit zu rechnen. Können die Wandler eine höhere Bandbreite, z.B. bis 500kHz, bereitstellen, dann sollten die Filter entsprechend dimensioniert werden.

Die Wanderwellen werden in Schritten 62 durch eine Transformation (z.B. Clarke-Transformation) behandelt, um die phasenbezogenen Anteile zu entkoppeln. Dabei werden transformierte Strom- und Spannungswerte erzeugt.

Um das Fehlerortungsverfahren nur bei Bedarf, d.h. im Fehlerfall, zu starten und/oder um das Messfenster für die Auswertung richtig zu positionieren, kann zudem in Schritt 63 ein transienter Sprung ermittelt werden, der z.B. als Trigger für die Messfensterpositionierung eingesetzt wird. Die Länge des Messfensters sollte bevorzugt mindestens das Doppelte der Propagationszeit der Wanderwelle in der ausgewählten Modalkomponente betragen. Die Sprungerkennung kann hinsichtlich der transformierten oder der gefilterten Strom- und Spannungswerte oder auch hinsichtlich der ursprünglichen Strom- und Spannungsmesswerte stattfinden.

In Schritt 64 findet eine Überführung der transformierten Strom- und Spannungswerte in den Frequenzbereich statt. Dies erfolgt bevorzugt mittels einer Fast Fourier Transformation (FFT) bzw. Discrete Fourier Transformation (DFT).

In Schritt 65 werden für den Knotenpunkt 11a berechnete transiente Verläufe von Strom und Spannung bereitgestellt. Diese sind entsprechend des oben erläuterten Verfahrens bestimmt worden und bilden den Verlauf des Knotenstroms und der Knotenspannung in entsprechender Weise wie die in Schritten 60 bis 64 bearbeiteten Messwerte ab.

Die in Schritten 64 und 65 bereitgestellten Verläufe von Strom und Spannung werden einem folgenden Schritt 66 zugeführt.

Im Schritt 66 führt die Einrichtung 50 eine Fehlerortbestimmung aus. Hierzu können beispielsweise die aus den Verläufen für die beiden Enden des Leitungsabschnitts gewonnenen Fehlerspannungsverläufe $U_{F,1}$, $U_{F,2}$ für einen angenommenen Fehlerort x auf dem Leitungsabschnitt ausgewertet werden:

$$U_{F,1}(x, j\omega)e^{-\gamma(j\omega)x} = U_1(j\omega)e^{-\gamma(j\omega)x}\cosh\gamma(j\omega)x -$$
$$Z_c(j\omega)\cdot I_1(j\omega)e^{-\gamma(j\omega)x}\sinh\gamma(j\omega)x$$

$$U_{F,2}(l-x, j\omega)e^{-\gamma(j\omega)(l-x)} = U_2(j\omega)e^{-\gamma(j\omega)(l-x)}\cosh\gamma(j\omega)(l-x) -$$
$$Z_c(j\omega)\cdot I_2(j\omega)e^{-\gamma(j\omega)(l-x)}\sinh\gamma(j\omega)(l-x)$$

Da der tatsächliche Fehlerort zunächst jedoch unbekannt ist, muss derjenige Wert für x gefunden werden, bei dem die beste Übereinstimmung der beiden Fehlerspannungsverläufe $U_{F,1}$, $U_{F,2}$ vorliegt. Mit anderen Worten muss zunächst einerseits von dem Leitungsende 12b für einen ersten fiktiven bzw. angenommenen Fehlerort der Verlauf der Fehlerspannungswerte $U_{F,1}$ und andererseits von dem Knotenpunkt 11a für denselben fiktiven bzw. angenommenen Fehlerort der Verlauf der Fehlerspannungswerte $U_{F,2}$ bestimmt werden. Sollten beide Verläufe übereinstimmen, würde der erste fiktive Fehlerort mit dem tatsächlichen Fehlerort übereinstimmen. Sofern keine Übereinstimmung vorliegt, muss dieselbe Vorgehensweise für einen nächsten fiktiven Fehlerort durchgeführt werden. Die Vorgehensweise wird so lange fortgesetzt, bis bei einem fiktiven Fehlerort eine Übereinstimmung der beiden Fehlerspannungsverläufe $U_{F,1}$, $U_{F,2}$ festgestellt wird; dieser fiktive Fehlerort entspricht dann dem tatsächlichen Fehlerort.

Die beschriebene Vorgehensweise kann vorteilhaft durch ein mathematisches Optimierungsverfahren ersetzt werden, bei dem eine Zielfunktion erstellt wird, mit der die beste Übereinstimmung der beiden Fehlerspannungsverläufe abhängig vom Fehlerort ermittelt werden kann. Als Parameter für die Zielfunktion kann die Entfernung x des Fehlerorts vom Leitungsende 12b verwendet werden. Für den tatsächlichen Fehlerort gilt also:

$$\left(U_{F,1}(x, j\omega)e^{-\gamma(j\omega)x} - U_{F,2}(l-x, j\omega)e^{-\gamma(j\omega)(l-x)}\right) \approx 0$$

Um die Bedingung zu erfüllen, lassen sich verschiedene Zielfunktionen erstellen. Eine mögliche Zielfunktion $ZF_1$, bei der zur Optimierung eine Minimierung stattfindet, ist durch nachfolgend dargestellte Gleichung angegeben:

$$ZF_1 = \min\int_\omega \left(U_{F,1}(x, j\omega)e^{-\gamma(j\omega)x} - U_{F,2}(l-x, j\omega)e^{-\gamma(j\omega)(l-x)}\right)^2$$

Eine andere mögliche Zielfunktion $ZF_2$, bei der zur Optimierung eine Maximierung stattfindet ist nachfolgend durch Gleichung angegeben:

$$ZF_2 = \max\int_\omega \left(U_{F,1}(x, j\omega)e^{-\gamma(j\omega)x} \cdot \left(U_{F,2}(l-x, j\omega)e^{-\gamma(j\omega)(l-x)}\right)^*\right)$$

Hierbei wird durch den Stern * der konjugiert komplexe Ausdruck bezeichnet.

Die oben genannten Gleichungen stellen beispielhafte Zielfunktionen dar, die einem Minimierungs- bzw. Maximierungsprozess auferlegt werden müssen. Dies kann beispielsweise durch ein mathematisches iteratives Verfahren gelöst werden. Den Minimierungs- bzw. Maximierungsprozess kann man sowohl im Frequenz- als auch im Zeitbereich durchführen, wobei die Berechnung der Fehlerspannungsverläufe bevorzugt im Frequenzbereich stattfindet. Da in digitalen Geräten wie der Einrichtung 50 üblicherweise mit diskreten Werten gearbeitet wird, können die Verfahren entsprechend dieser Anforderung angepasst werden.

Dabei können in Schritt 66 beispielsweise die genannten Zielfunktionen verarbeitet werden. Wie oben beschrieben wird dabei ein möglicher Fehlerort gesucht, für den die Zielfunktion des betrachteten Leitungsabschnitts ein Minimum bzw. ein Maximum hat.

In Schritt 67 wird dann der ermittelte Fehlerort ausgegeben. Die Einrichtung 50 besitzt üblicherweise eine Recheneinrichtung, in der die Schritte 60 bis 67 durchgeführt werden. Dabei kann es sich z.B. um einen Mikroprozessor handeln, der auf eine entsprechende Gerätesoftware zugreift, die sich in einem Speicher der jeweiligen Einrichtung befindet. Alternativ kann es sich auch um einen Rechenbaustein mit hardwarebestimmter Programmierung handeln, z.B. einen ASIC oder FPGA. Anstelle einer Einrichtung 50, die prozessnah, also in der Nähe der Messstelle des Leitungsabschnitts angeordnet ist, kann die Ermittlung des möglichen Fehlerortes auch in einer entfernt angeordneten zentralen Datenverarbeitungseinrichtung stattfinden. Diese kann auch durch ein Cloudcomputingsystem gebildet sein, das die Fehlerortbestimmung als Service anbietet.

Pro Leitungsabschnitt findet in der oben beschriebenen Weise die Bestimmung eines möglichen Fehlerortes statt. Hierzu wird jeweils eine für den fraglichen Leitungsabschnitt spezifische Zielfunktion gebildet und der Optimierung unterzogen. Zur Erkennung des tatsächlichen Fehlerortes werden daraufhin die Ergebnisse der einzelnen Fehlerortbestimmungen miteinander verglichen. Hierzu werden alle Zielfunktionen zusammengestellt und ein globales Extremum ermittelt. Dieses Extremum deutet auf die fehlerbehaftete Leitung sowie den tatsächlichen Fehlerort hin.

Diese Vorgehensweise kann anhand von Figur 7 erläutert werden. Figur 7 zeigt ein Diagramm, in dem beispielhaft für die Leitungsabschnitte 10a, 10b und 10f (vgl. Figur 2) die Verläufe der analysierten Zielfunktionen dargestellt werden. Diese Leitungsabschnitte treffen sich am Knotenpunkt 11a. Der Verlauf der Zielfunktion über Leitungsabschnitt 10a ist mit dem Bezugszeichen 70a bezeichnet. In entsprechender Weise sind die Verläufe der Zielfunktionen für die Leitungsabschnitte 10b und 10f mit den Bezugszeichen 70b und 70f gekennzeichnet. Beim Vergleich der Verläufe der drei Zielfunktionen erkennt man, dass der Verlauf 70b ein globales Minimum aufweist. Dieses Minimum deutet auf den tatsächlichen Fehlerort F hin. Somit kann durch Vergleich der betrachteten Zielfunktionen diejenige ausgewählte werden, die am deutlichsten auf einen tatsächlich vorliegenden Fehler hinweist. Der von diesem Verlauf angegebene mögliche Fehlerort wird als tatsächlicher Fehlerort verwendet.

Es kann auch vorkommen, dass einzelne oder alle Leitungsabschnitte segmentiert sind, d.h. sie setzen sich teilweise aus unterirdisch verlaufenden Kabeln und teilweise aus Freileitungen zusammen. Die einzelnen Segmente werden von verschiedenen Parametern gekennzeichnet. Nachfolgend wird kurz beschrieben, wie auch für solche segmentierten Leitungsabschnitte entsprechende Wanderwellenmodelle aufgestellt werden können. Dabei werden zwei mögliche Varianten beschrieben.

Bei der ersten Variante wird davon ausgegangen, dass die zu berechnende Knoten-Admittanz-Matrix aus einzelnen Übertragungsstrecken zusammengestellt wird, die kurzschlussfrei sind. Die Mischstrecken sind dann in Form eines PI-Gliedes darstellbar. Jede Strecke lässt sich durch einen separaten Vierpol in Form von sogenannten Kettenparametern beschreiben:

$$\begin{bmatrix} \cosh \gamma l & -\underline{Z}_c \sinh \gamma l \\ -\dfrac{\sinh \gamma l}{\underline{Z}_c} & \cosh \gamma l \end{bmatrix} \rightarrow \begin{bmatrix} A & -B \\ -C & D \end{bmatrix}$$

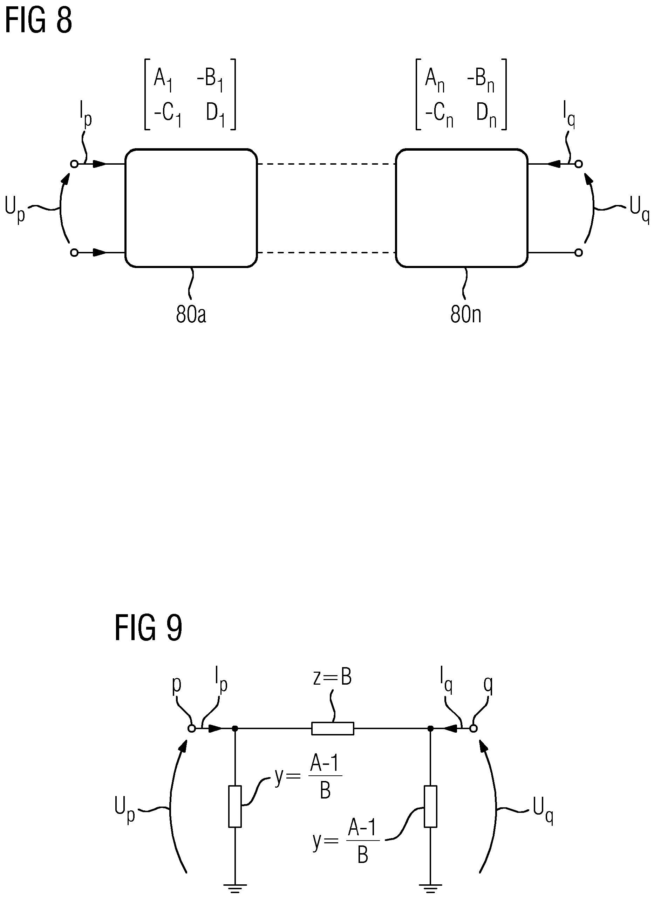

Im Fall solcher Mischstrecken kann die Beschreibung des Wanderwellenmodells wie in Figur 8 dargestellt erfolgen. Für jedes Segment 1...n wird aus den entsprechenden Leitungsparametern ein Kettenglied 80a ... 80n mit jeweiligen Kettenparametern $A_a$, $B_a$, $C_a$, $D_a$ ... $A_n$, $B_n$, $C_n$, $D_n$ erzeugt. Zur Darstellung des gesamten Leitungsabschnitts kann folgende Gleichung verwendet werden, die das Produkt der Matrizen mit ihren Kettenparametern ausdrückt:

$$\begin{bmatrix} \underline{U}_p \\ \underline{I}_p \end{bmatrix} = \begin{bmatrix} A_1 & -B_1 \\ -C_1 & D_1 \end{bmatrix} \cdot \ \cdots \ \cdot \begin{bmatrix} A_n & -B_n \\ -C_n & D_n \end{bmatrix} \cdot \begin{bmatrix} \underline{U}_q \\ \underline{I}_q \end{bmatrix}$$

Das führt zu einem Vierpol, der die ganze Mischstrecke abbildet:

$$\begin{bmatrix} \underline{U}_p \\ \underline{I}_p \end{bmatrix} = \begin{bmatrix} A & -B \\ -C & D \end{bmatrix} \cdot \begin{bmatrix} \underline{U}_q \\ \underline{I}_q \end{bmatrix}$$

Aus dem Vierpol lässt sich ein PI-Glied erstellen, wie es beispielhaft in Figur 9 dargestellt ist. Dieses kann wie oben beschrieben zur Modellierung des jeweiligen Leitungsabschnitts verwendet werden.

Bei der zweiten Alternative wird davon ausgegangen, dass die Fehlerortung an einem Leitungsabschnitt erfolgt, der nicht über Knoten-Admittanz-Matrix abgebildet wird. Dieser Leitungsabschnitt wird dann als die fehlerbehaftete Leitung betrachtet. Nach der Berechnung der Strom- und Spannungsgrößen der für die Fehlerortberechnung relevanten stellen erfolgt die Schätzung der Spannung an der theoretischen Fehlerstelle. Diese Schätzung wird über die ganze Leitung unter Berücksichtigung von Segmenten durchgeführt.

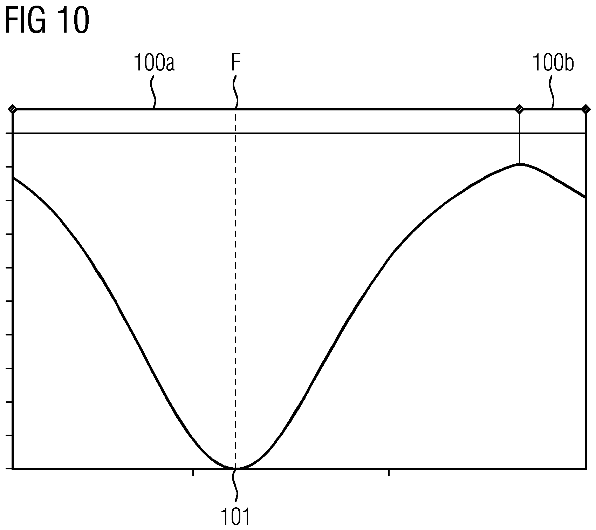

Figur 10 ist es zu entnehmen, wie die Zielfunktion für die Schätzung des Fehlerortes auf einem Leitungsabschnitt mit zwei Segmenten 100a, 100b verläuft. Deutlich ist ein Minimum 101 zu sehen, welches auf den Fehlerort schließen lässt.

Zusammengefasst wurde vorliegend eine Methode beschrieben, wie eine Fehlerortbestimmung bezüglich einer verzweigten Leitung unter Verwendung von Transienten durchgeführt wird, wenn nicht an allen relevanten Stellen, insbesondere an den Knotenpunkten, Strom- und Spannungssignale messbar sind. Damit vereinfacht die Methode den Ausbau vorhandener Netze, insbesondere das Verwenden mehrere Leitungsabzweige, für die bisher kein vergleichbar zuverlässiges Verfahren zur Fehlerortung verfügbar war. Damit ermöglicht die Methode Problemlösungen beim Ausbau erneuerbarer Energien, insbesondere den effektiven und kostengünstigen Anschluss von dezentraler Erzeugung an vorhandene Netze.

Hierzu werden für eine zu untersuchende verzweigte Leitung die fehlenden Strom- und Spannungssignale von Knotenpunkten, von denen keine Messsignale vorliegen, aus den vorhandenen Messsignalen gebildet. Dazu müssen für alle Knotenpunkte, für die keine Messsignale vorliegen, die Messsignale anhand der vorhandenen Messungen ermittelt. Zur Bildung der fehlenden Messsignale wird ein Wanderwellenmodell, vorzugsweise nach dem Knoten-Admittanz-Verfahren eingesetzt. Weiterhin wird sukzessiv ein Leitungsabschnitt selektiert, für dessen Enden entweder die vorhandenen Messsignale verwendet werden oder die Signale aus den gemessenen Messsignalen wie beschrieben gebildet werden. Mit den nun verfügbaren Messsignalen von beiden Enden des Leitungsabschnitts kann nun ein Verfahren zur beidseitigen Fehlerortung verwendet werden. Aus der Betrachtung der jeweiligen Extrema der jeweiligen Zielfunktionen kann letztlich anhand des absoluten (globalen) Extremums auf den tatsächlichen Fehlerort geschlossen werden.

Obwohl die Erfindung vorstehend im Detail durch bevorzugte Ausführungsbeispiele näher illustriert und beschrieben worden ist, ist die Erfindung nicht durch die offenbarten Beispiele eingeschränkt und andere Variationen können vom Fachmann hieraus abgeleitet werden, ohne den Schutzumfang der nachfolgenden Patentansprüche zu verlassen.

## Patentansprüche

1. Verfahren zum Ermitteln des Fehlerortes eines Fehlers auf einer Leitung (10) eines elektrischen Energieversorgungsnetzes, wobei an den Leitungsenden (12a-e) der Leitung mittels Einrichtungen (50) transiente Verläufe von Strom- und Spannungswerten gemessen werden; und

    - unter Verwendung der transienten Verläufe von Strom- und Spannungswerten nach dem Auftreten eines Fehlers auf der Leitung (10) dessen Fehlerort (F) bestimmt wird;

   wobei

    - die Leitung (10) einen ersten Leitungsabschnitt (10a) mit einem ersten Leitungsende (12a), einen zweiten Leitungsabschnitt (10b) mit einem zweiten Leitungsende (12b) und zumindest einen weiteren Leitungsabschnitt (10n) mit einem weiteren Leitungsende (12n) sowie zumindest einen Knotenpunkt (11) aufweist, an dem sich mehr als zwei der Leitungsabschnitte (10a, 10b, 10n) treffen,
    - transiente Verläufe eines Knotenstroms und einer Knotenspannung an dem zumindest einen Knotenpunkt (11) unter Verwendung zumindest der Strom- und Spannungswerte eines Leitungsendes (12a, 12b, 12n) sowie eines Wanderwellenmodells für den jeweiligen Leitungsabschnitt (10a, 10b, 10n) bestimmt werden; und
    - für jeden Leitungsabschnitt (10a, 10b, 10n) unter Verwendung einerseits des transienten Verlaufs der an dessen Leitungsende (12a, 12b, 12n) gemessenen Strom- und Spannungswerte und andererseits des Knotenstroms und der Knotenspannung sowie des Wanderwellenmodells für diesen Leitungsabschnitt (10a, 10b, 10n) eine zweiseitige Fehlerortbestimmung durchgeführt wird, wobei
    - bei der Bestimmung des Knotenstroms und der Knotenspannung die Strom- und Spannungswerte desjenigen Leitungsendes (12a, 12b, 12n) ausgeschlossen werden, das den jeweils zur Fehlerortbestimmung betrachteten Leitungsabschnitt (10a, 10b, 10n) begrenzt.

**2.** Verfahren nach Anspruch 1,
**dadurch gekennzeichnet, dass**

- die Fehlerortbestimmung anhand einer Zeitdifferenz durchgeführt wird, mit der eine Strom- oder eine Spannungsflanke einer Wanderwelle an den beiden Enden des jeweiligen Leitungsabschnitts (10a, 10b, 10n) eintrifft.

**3.** Verfahren nach Anspruch 1,
**dadurch gekennzeichnet, dass**

- mittels der Fehlerortbestimmung für die einzelnen Leitungsabschnitte (10a, 10b, 10n) jeweils mögliche Fehlerorte ermittelt werden; und
- derjenige mögliche Fehlerort als tatsächlicher Fehlerort ausgewählt wird, bei dem die Fehlerortbestimmung im Vergleich zu den anderen möglichen Fehlerorten am deutlichsten auf einen an einem bestimmten Ort vorliegenden Fehler hinweist.

**4.** Verfahren nach Anspruch 3,
**dadurch gekennzeichnet, dass**

- zur Fehlerortbestimmung für jeden Leitungsabschnitt (10a, 10b, 10n) geprüft wird, ob es auf dessen Länge einen Ort gibt, an dem von beiden Enden des Leitungsabschnitts (10a, 10b, 10n) berechnete zeitliche Profile einer an diesem Ort vorliegenden Spannung und/oder eines an diesem Ort vorliegenden Stromes übereinstimmen; und
- ein solcher Ort als möglicher Fehlerort für den jeweiligen Leitungsabschnitt (10a, 10b, 10n) verwendet wird.

**5.** Verfahren nach Anspruch 4,
**dadurch gekennzeichnet, dass**

- die Ermittlung des möglichen Fehlerortes mittels eines Optimierungsverfahrens erfolgt, wobei der Fehlerort als Optimierungsgröße einer Zielfunktion des Optimierungsverfahrens verwendet wird.

**6.** Verfahren nach Anspruch 5,
**dadurch gekennzeichnet, dass**

- eine Minimierung der Zielfunktion in Form einer Differenz der von den jeweiligen Enden des jeweiligen Leitungsabschnitts (10a, 10b, 10n) berechneten zeitlichen Profile durchgeführt wird und als möglicher Fehlerort auf dem jeweiligen Leitungsabschnitt (10a, 10b, 10n) derjenige Ort angesehen wird, an dem die Zielfunktion ein Minimum einnimmt; oder
- eine Maximierung der Zielfunktion in Form eines Produktes des zeitlichen Profils von dem einen Ende des jeweiligen Leitungsabschnitts (10a, 10b, 10n) sowie des konjugiert komplexen Verlaufs des zeitlichen Profils von dem anderen Ende des jeweiligen Leitungsabschnitts durchgeführt wird und als möglicher Fehlerort auf dem jeweiligen Leitungsabschnitt (10a, 10b, 10n) derjenige Ort angesehen wird, an dem die Zielfunktion ein Maximum einnimmt.

**7.** Verfahren nach Anspruch 5 oder 6,
**dadurch gekennzeichnet, dass**

- die Verläufe der jeweiligen Zielfunktion aller Leitungsabschnitte miteinander verglichen werden, und derjenige mögliche Fehlerort als tatsächlicher Fehlerort ausgewählt wird, dessen Zielfunktion im Vergleich zu den Zielfunktionen der anderen möglichen Fehlerorte ein globales Extremum aufweist.

**8.** Verfahren nach einem der vorangehenden Ansprüche,
**dadurch gekennzeichnet, dass**

- bei einer Leitung (10) mit mehr als einem Knotenpunkt (11a, 11b, 11c) die transienten Verläufe des jeweiligen Knotenstroms und der jeweiligen Knotenspannung für jeden Knotenpunkt (11a, 11b, 11c) bestimmt werden; und
- auf zwischen zwei Knotenpunkten (11a, 11b, 11c) liegenden Leitungsabschnitten (10f, 10g) eine zweiseitige Fehlerortbestimmung unter Verwendung der für die jeweiligen Knotenpunkte (11a, 11b, 11c) bestimmten transienten Verläufe des Knotenstroms und der Knotenspannung durchgeführt wird.

9. Verfahren nach einem der vorangehenden Ansprüche,
**dadurch gekennzeichnet, dass**

- der Knotenstrom und die Knotenspannung bei einem der Leitungsabschnitte (10a, 10b, 10n), der teilweise als Freileitung und teilweise als unterirdisches Kabel ausgebildet ist, anhand eines Wanderwellenmodells bestimmt werden, das Leitungsparameter sowohl der Freileitung als auch des unterirdischen Kabels berücksichtigt.

10. Verfahren nach einem der vorangehenden Ansprüche,
**dadurch gekennzeichnet, dass**

- die an den Leitungsenden (12a-e) gemessenen Strom- und Spannungswerte einer Filterung unterzogen werden, wobei gefilterte Strom- und Spannungswerte gebildet werden, die einen ausgewählten Frequenzbereich der gemessenen Strom- und Spannungswerte angeben, wobei der ausgewählte Frequenzbereich hochfrequente transiente Anteile oder bandbegrenzte transiente Anteile der gemessenen Strom- und Spannungswerte umfasst.

11. Verfahren nach einem der Ansprüche 9 oder 10,
**dadurch gekennzeichnet, dass**

- die Filtercharakteristik des zur Filterung der Strom- und Spannungswerte benutzten Filters solche Frequenzbereiche bedämpft, in denen zur Messung der Strom- und Spannungsmesswerte verwendete Strom- bzw. Spannungswandler Messfehler aufweisen.

12. Verfahren nach einem der vorangehenden Ansprüche,
**dadurch gekennzeichnet, dass**

- die Strom- und Spannungswerte an den Leitungsenden (10a, 10b, 10n) durch Abtastung von analogen Strom- und Spannungssignalen mit einer Abtastfrequenz oberhalb der Grundfrequenz der Signale, vorzugsweise mit einer Abtastrate zwischen 8kHz und 64kHz, erfasst werden.

13. Einrichtung (50) zum Ermitteln des Fehlerortes eines Fehlers auf einer Leitung (10) eines elektrischen Energieversorgungsnetzes, mit

- einer Messanordnung, die dazu eingerichtet ist, transiente Verläufe von Strom- und Spanungswerten an einem Leitungsende (12a, 12b, 12n) der Leitung (10) zu messen; und
- einer Recheneinrichtung, die dazu eingerichtet ist, unter Verwendung der von der Messanordnung gemessenen transienten Verläufe der Strom- und Spannungswerte nach dem Auftreten eines Fehlers auf der Leitung (10) dessen Fehlerort (F) zu bestimmen;

wobei

- die Leitung (10) einen ersten Leitungsabschnitt (10a) mit einem ersten Leitungsende (12a), einen zweiten Leitungsabschnitt (10b) mit einem zweiten Leitungsende (12b) und zumindest einen weiteren Leitungsabschnitt (10n) mit einem weiteren Leitungsende (12n) sowie zumindest einen Knotenpunkt (11) aufweist, an dem sich mehr als zwei der Leitungsabschnitte (10a, 10b, 10n) treffen,
- die Recheneinrichtung dazu eingerichtet ist, transiente Verläufe eines Knotenstroms und einer Knotenspannung an dem zumindest einen Knotenpunkt (11) unter Verwendung zumindest der Strom- und Spannungswerte eines Leitungsendes (12a, 12b, 12n) sowie eines Wanderwellenmodells für den jeweiligen Leitungsabschnitt (10a, 10b, 10n) zu bestimmen; und
- die Recheneinrichtung dazu eingerichtet ist, für jeden Leitungsabschnitt (10a, 10b, 10n) unter Verwendung einerseits des transienten Verlaufs der an dessen Leitungsende (12a, 12b, 12n) gemessenen Strom- und Spannungswerte und andererseits des Knotenstroms und der Knotenspannung sowie des Wanderwellenmodells für diesen Leitungsabschnitt (10a, 10b, 10n) eine zweiseitige Fehlerortbestimmung durchzuführen, wobei
- bei der Bestimmung des Knotenstroms und der Knotenspannung die Strom- und Spannungswerte desjenigen Leitungsendes (12a, 12b, 12n) ausgeschlossen werden, das den jeweils zur Fehlerortbestimmung betrachteten Leitungsabschnitt (10a, 10b, 10n) begrenzt.

14. System zum Ermitteln des Fehlerortes eines Fehlers auf einer Leitung (10) eines elektrischen Energieversorgungsnetzes, mit

- mehreren Messeinrichtungen, die dazu eingerichtet sind, transiente Verläufe von Strom- und Spanungswerten an den Leitungsenden (12a, 12b, 12n) der Leitung (10) zu messen; und
- mindestens einer Recheneinrichtung, die dazu eingerichtet ist, unter Verwendung der transienten Verläufe der Strom- und Spannungswerte nach dem Auftreten eines Fehlers auf der Leitung (10) dessen Fehlerort (F) zu bestimmen;

wobei

- die Leitung (10) einen ersten Leitungsabschnitt (10a) mit einem ersten Leitungsende (12a), einen zweiten Leitungsabschnitt (10b) mit einem zweiten Leitungsende (12b) und zumindest einen weiteren Leitungsabschnitt (10n) mit einem weiteren Leitungsende (10n) sowie zumindest einen Knotenpunkt (11) aufweist, an dem sich mehr als zwei der Leitungsabschnitte (10a, 10b, 10n) treffen,
- die Recheneinrichtung dazu eingerichtet ist, transiente Verläufe eines Knotenstroms und einer Knotenspannung an dem zumindest einen Knotenpunkt (11) unter Verwendung zumindest der Strom- und Spannungswerte eines Leitungsendes (12a, 12b, 12n) sowie eines Wanderwellenmodells für den jeweiligen Leitungsabschnitt (10a, 10b, 10n) zu bestimmen; und
- die Recheneinrichtung dazu eingerichtet ist, für jeden Leitungsabschnitt (10a, 10b, 10n) unter Verwendung einerseits des transienten Verlaufs der an dessen Leitungsende (12a, 12b, 12n) gemessenen Strom- und Spannungswerte und andererseits des Knotenstroms und der Knotenspannung sowie des Wanderwellenmodells für diesen Leitungsabschnitt (10a, 10b, 10n) eine zweiseitige Fehlerortbestimmung durchzuführen, wobei
- bei der Bestimmung des Knotenstroms und der Knotenspannung die Strom- und Spannungswerte desjenigen Leitungsendes (12a, 12b, 12n) ausgeschlossen werden, das den jeweils zur Fehlerortbestimmung betrachteten Leitungsabschnitt (10a, 10b, 10n) begrenzt.

## Claims

1. Method for identifying the fault location of a fault on a line (10) of an electrical power supply network, wherein transient characteristics of current and voltage values are measured at the line ends (12a-e) of the line by means of devices (50); and,

    - after a fault has occurred on the line (10), its fault location (F) is determined using the transient characteristics of current and voltage values;

    wherein

    - the line (10) has a first line section (10a) with a first line end (12a), a second line section (10b) with a second line end (12b) and at least one further line section (10n) with a further line end (12n) and at least one node (11) at which more than two of the line sections (10a, 10b, 10n) meet,
    - transient characteristics of a node current and a node voltage at the at least one node (11) are determined using at least the current and voltage values of a line end (12a, 12b, 12n) and a travelling wave model for the respective line section (10a, 10b, 10n); and
    - for each line section (10a, 10b, 10n), a double-ended fault location determination is carried out using the transient characteristic of the current and voltage values measured at its line end (12a, 12b, 12n), on the one hand, and the node current and the node voltage and the travelling wave model for this line section (10a, 10b, 10n), on the other hand, wherein,
    - when determining the node current and the node voltage, the current and voltage values of that line end (12a, 12b, 12n) that bounds the line section (10a, 10b, 10n) considered in each case for the fault location determination are excluded.

2. Method according to Claim 1,
    **characterized in that**

    - the fault location determination is carried out on the basis of a time difference with which a current edge or a voltage edge of a travelling wave arrives at the two ends of the respective line section (10a, 10b, 10n).

**3.** Method according to Claim 1,
**characterized in that**

- possible fault locations are identified in each case by means of the fault location determination for the individual line sections (10a, 10b, 10n); and
- that possible fault location at which the fault location determination most clearly indicates a fault existing at a particular location in comparison with the other possible fault locations is selected as the actual fault location.

**4.** Method according to Claim 3,
**characterized in that**,

- for the fault location determination, a check is performed for each line section (10a, 10b, 10n) to ascertain whether there is a location over the length of said line section at which time profiles, calculated from the two ends of the line section (10a, 10b, 10n), of a voltage present at this location and/or of a current present at this location match; and
- such a location is used as a possible fault location for the respective line section (10a, 10b, 10n).

**5.** Method according to Claim 4,
**characterized in that**

- the possible fault location is identified by means of an optimization method, wherein the fault location is used as an optimization variable of a target function of the optimization method.

**6.** Method according to Claim 5,
**characterized in that**

- a minimization of the target function in the form of a difference between the time profiles calculated from the respective ends of the respective line section (10a, 10b, 10n) is carried out, and that location at which the target function assumes a minimum is regarded as a possible fault location on the respective line section (10a, 10b, 10n); or
- a maximization of the target function in the form of a product of the time profile from one end of the respective line section (10a, 10b, 10n) and the complex conjugate characteristic of the time profile from the other end of the respective line section is carried out, and that location at which the target function assumes a maximum is regarded as a possible fault location on the respective line section (10a, 10b, 10n).

**7.** Method according to Claim 5 or 6,
**characterized in that**

- the characteristics of the respective target function of all the line sections are compared with one another, and that possible fault location whose target function has a global extremum in comparison with the target functions of the other possible fault locations is selected as the actual fault location.

**8.** Method according to one of the preceding claims,
**characterized in that**

- in the case of a line (10) with more than one node (11a, 11b, 11c), the transient characteristics of the respective node current and of the respective node voltage are determined for each node (11a, 11b, 11c); and
- a double-ended fault location determination is carried out on line sections (10f, 10g) situated between two nodes (11a, 11b, 11c) using the transient characteristics, determined for the respective nodes (11a, 11b, 11c), of the node current and of the node voltage.

**9.** Method according to one of the preceding claims,
**characterized in that**,

- in the case of one of the line sections (10a, 10b, 10n) that is configured partially as an overhead line and partially as an underground cable, the node current and the node voltage are determined on the basis of a travelling wave model that takes into consideration line parameters both of the overhead line and of the underground cable.

**10.** Method according to one of the preceding claims,
**characterized in that**

- the current and voltage values measured at the line ends (12a-e) are subjected to filtering, wherein filtered current and voltage values are formed that indicate a selected frequency range of the measured current and voltage values, wherein the selected frequency range comprises high-frequency transient components or band-limited transient components of the measured current and voltage values.

**11.** Method according to one of Claims 9 and 10,
**characterized in that**

- the filter characteristic of the filter used for filtering the current and voltage values attenuates those frequency ranges in which current or voltage transformers used for measuring the current and voltage measured values have measurement errors.

**12.** Method according to one of the preceding claims,
**characterized in that**

- the current and voltage values at the line ends (10a, 10b, 10n) are captured by sampling analogue current and voltage signals at a sampling frequency above the fundamental frequency of the signals, preferably at a sampling rate of between 8 kHz and 64 kHz.

**13.** Device (50) for identifying the fault location of a fault on a line (10) of an electrical power supply network, comprising

- a measuring arrangement that is designed to measure transient characteristics of current and voltage values at a line end (12a, 12b, 12n) of the line (10); and
- a computing device that is designed, after a fault has occurred on the line (10), to determine its fault location (F) using the transient characteristics, measured by the measuring arrangement, of the current and voltage values;

wherein

- the line (10) has a first line section (10a) with a first line end (12a), a second line section (10b) with a second line end (12b) and at least one further line section (10n) with a further line end (12n) and at least one node (11) at which more than two of the line sections (10a, 10b, 10n) meet,
- the computing device is designed to determine transient characteristics of a node current and a node voltage at the at least one node (11) using at least the current and voltage values of a line end (12a, 12b, 12n) and a travelling wave model for the respective line section (10a, 10b, 10n); and
- the computing device is designed to carry out a double-ended fault location determination for each line section (10a, 10b, 10n) using the transient characteristic of the current and voltage values measured at its line end (12a, 12b, 12n), on the one hand, and the node current and the node voltage and the travelling wave model for this line section (10a, 10b, 10n), on the other hand, wherein,
- when determining the node current and the node voltage, the current and voltage values of that line end (12a, 12b, 12n) that bounds the line section (10a, 10b, 10n) considered in each case for the fault location determination are excluded.

**14.** System for identifying the fault location of a fault on a line (10) of an electrical power supply network, comprising

- a plurality of measuring devices that are designed to measure transient characteristics of current and voltage values at the line ends (12a, 12b, 12n) of the line (10); and
- at least one computing device that is designed, after a fault has occurred on the line (10), to determine its fault location (F) using the transient characteristics of the current and voltage values;

wherein

- the line (10) has a first line section (10a) with a first line end (12a), a second line section (10b) with a second line end (12b) and at least one further line section (10n) with a further line end (10n) and at least one node (11) at which more than two of the line sections (10a, 10b, 10n) meet,

- the computing device is designed to determine transient characteristics of a node current and a node voltage at the at least one node (11) using at least the current and voltage values of a line end (12a, 12b, 12n) and a travelling wave model for the respective line section (10a, 10b, 10n); and
- the computing device is designed to carry out a double-ended fault location determination for each line section (10a, 10b, 10n) using the transient characteristic of the current and voltage values measured at its line end (12a, 12b, 12n), on the one hand, and the node current and the node voltage and the travelling wave model for this line section (10a, 10b, 10n), on the other hand, wherein,
- when determining the node current and the node voltage, the current and voltage values of that line end (12a, 12b, 12n) that bounds the line section (10a, 10b, 10n) considered in each case for the fault location determination are excluded.

**Revendications**

1. Procédé de détermination de l'emplacement d'un défaut sur une ligne (10) d'un réseau d'alimentation en énergie électrique, dans lequel on mesure aux bouts (12a-e) de la ligne, au moyen de dispositifs (50), des courbes transitoires de valeurs de courant et de tension ; et

   - en utilisant les courbes transitoires de valeurs de courant et de tension, on détermine, après l'apparition d'un défaut sur la ligne (10), l'emplacement (F) du défaut ;

   dans lequel

   - la ligne (10) a un premier tronçon (10a) ayant un premier bout (12a), un deuxième tronçon (10b) ayant un deuxième bout (12b) et au moins un autre tronçon (10n) ayant un autre bout (12n), ainsi qu'au moins un point (11) nodal où plus de deux des tronçons (10a, 10b, 10n) de la ligne se rencontrent,
   - on détermine des courbes transitoires d'un courant nodal et d'une tension nodale au au moins un point (11) nodal, en utilisant au moins les valeurs de courant et de tension d'un bout (12a, 12b, 12n) de ligne, ainsi qu'un modèle d'onde progressive pour le tronçon (10a, 10b, 10b) de ligne respectif ; et
   - pour chaque tronçon (10a, 10b, 10n ) de ligne, on effectue en utilisant d'une part la courbe transitoire des valeurs de courant et de tension mesurées à son bout (12a, 12b, 12n) de ligne et d'autre part le courant nodal et la tension nodale, ainsi que le modèle d'onde progressive pour ce tronçon (10a, 10b, 10n) de ligne, un détermination bilatérale de l'emplacement du défaut, dans lequel
   - lors de la détermination du courant nodal et de la tension nodale, on exclut les valeurs de courant et de tension du bout (12a, 12b, 12n) de ligne, qui limite le tronçon (10a, 10b, 10n) de ligne considéré respectivement pour la détermination de l'emplacement du défaut.

2. Procédé suivant la revendication 1,
   **caractérisé en ce que**

   - on effectue la détermination de l'emplacement du défaut à l'aide d'une différence de temps, avec laquelle un flanc de courant ou de tension d'une onde progressive arrive aux deux bouts du tronçon (10a, 10b, 10n) de ligne respectif.

3. Procédé suivant la revendication 1,
   **caractérisé en ce que**

   - au moyen de la détermination de l'emplacement du défaut, on détermine respectivement des emplacements possibles du défaut pour les divers tronçons (10a, 10b, 10n) de ligne ; et
   - on sélectionne, comme emplacement réel du défaut, celui des emplacements possibles du défaut pour lequel la détermination de l'emplacement du défaut, par rapport à d'autres emplacements possibles du défaut, indique le plus nettement un défaut se produisant en un emplacement déterminé.

4. Procédé suivant la revendication 3,
   **caractérisé en ce que**

   - pour la détermination de l'emplacement du défaut, on contrôle, pour chaque tronçon (10a, 10b, 10n) de ligne, s'il y a sur sa longueur un emplacement où des profils temporels calculés à partir des deux bouts du tronçon (10a, 10b, 10n) de ligne d'une tension présente à cet emplacement et/ou d'un courant présent à cet emplacement coïncident ; et
- on utilise un tel emplacement comme emplacement possible de défaut pour le tronçon (10a, 10b, 10n) de ligne respectif.

5. Procédé suivant la revendication 4,
   **caractérisé en ce que**

   - la détermination de l'emplacement possible du défaut s'effectue au moyen d'un procédé d'optimisation, dans lequel on utilise l'emplacement du défaut comme grandeur d'optimisation d'une fonction cible du procédé d'optimisation.

6. Procédé suivant la revendication 5,
   **caractérisé en ce que**

   - on effectue une minimisation de la fonction cible, sous la forme d'une différence entre les profils temporels calculés à partir des bouts respectifs du tronçon (10a, 10b, 10n) de ligne respectif, et on considère, comme emplacement possible du défaut sur le tronçon (10a, 10b, 10n) de ligne respectif, l'emplacement où la fonction cible passe par un minimum ; ou
   - on effectue une maximisation de la fonction cible, sous la forme d'un produit du profil temporel, à partir du un bout du tronçon (10a, 10b, 10n) de ligne respectif, ainsi que de la courbe complexe conjuguée du profil temporel de l'autre bout du tronçon de ligne respectif et on considère, comme emplacement possible du défaut sur le tronçon (10a, 10b, 10n) de ligne respectif, l'emplacement où la fonction cible passe par un maximum.

7. Procédé suivant la revendication 5 ou 6,
   **caractérisé en ce que**

   - on compare les unes aux autres les courbes de la fonction cible respective de tous les tronçons de ligne pour sélectionner, comme emplacement réel du défaut, l'emplacement possible du défaut dont la fonction cible a, par rapport aux fonctions cibles des autres emplacements possibles du défaut, un extrémum global.

8. Procédé suivant l'une des revendications précédentes,
   **caractérisé en ce que**

   - pour une ligne (10) ayant plus qu'un point (11a, 11b, 11c) nodal, on détermine les courbes transitoires du courant nodal respectif et de la tension nodale respective pour chaque point (11a, 11b, 11c) nodal ; et
   - on effectue, sur des tronçons (10f, 10g) de ligne se trouvant entre deux points (11a, 11b, 11c) nodaux, une détermination bilatérale de l'emplacement du défaut en utilisant les courbes transitoires, déterminées pour les points (11a, 11b, 11c) nodaux respectifs, du courant nodal et de la tension nodale.

9. Procédé suivant l'une des revendications précédentes,
   **caractérisé en ce que**

   - on détermine le courant nodal et la tension nodale pour l'un des tronçons (10a, 10b, 10n) de ligne, qui est formé en partie sous la forme d'une ligne aérienne et en partie sous la forme d'un câble souterrain, à l'aide d'un modèle d'onde progressive, qui prend en compte des paramètres de ligne tant de la ligne aérienne qu'également du câble souterrain.

10. Procédé suivant l'une des revendications précédentes,
    **caractérisé en ce que**

    - on soumet à un filtrage les valeurs de courant et de tension mesurées aux bouts (12a-e) de ligne, dans lequel on forme des valeurs filtrées de courant et de tension, qui indiquent une plage de fréquence sélectionnée des valeurs mesurées de courant et de tension, dans lequel la plage de fréquence sélectionnée comprend des proportions transitoires de haute fréquence ou des proportions transitoires limitées en bande des valeurs mesurées de courant et de tension.

11. Procédé suivant l'une des revendications 9 ou 10,

**caractérisé en ce que**

- la caractéristique de filtrage du filtre utilisé pour le filtrage des valeurs de courant et de tension amortit les plages de fréquence, dans lesquelles des capteurs de courant ou de tensions utilisés pour la mesure des valeurs de mesure de courant et de tension présentent des erreurs de mesure.

12. Procédé suivant l'une des revendications précédentes,
**caractérisé en ce que**

- on relève des valeurs de courant et de tension aux bouts (10a, 10b, 10n) de ligne en échantillonnant des signaux analogiques de courant et de tension à une fréquence d'échantillonnage supérieure à la fréquence fondamentale des signaux, de préférence à un taux d'échantillonnage compris entre 8 kHz et 64 kHz.

13. Dispositif (50) de détermination de l'emplacement d'un défaut sur une ligne (10) d'un réseau d'alimentation en énergie électrique, comprenant :

- un montage de mesure, qui est conçu pour mesurer des courbes transitoires de valeurs de courant et de tension à un bout (12a, 12b, 12n) de la ligne (10) ; et
- un dispositif informatique, qui est conçu pour, en utilisant les courbes transitoires mesurées par le montage de mesure des valeurs de courant et de tension, déterminer, après l'apparition d'un défaut sur la ligne (10), l'emplacement (F) du défaut ; dans lequel
- la ligne (10) a un premier tronçon (10a) ayant un premier bout (12a), un deuxième tronçon (10b) ayant un deuxième bout (12b) et au moins un autre tronçon (10n) ayant un autre bout (12n), ainsi qu'au moins un point (11) nodal où plus de deux des tronçons (10a, 10b, 10n) de la ligne se rencontrent,
- le dispositif informatique est conçu pour déterminer des courbes transitoires d'un courant nodal et d'une tension nodale au au moins un point (11) nodal, en utilisant au moins les valeurs de courant et de tension d'un bout (12a, 12b, 12n) de ligne, ainsi qu'un modèle d'onde progressive pour le tronçon (10a, 10b, 10b) de ligne respectif ; et
- le dispositif informatique est conçu pour effectuer, pour chaque tronçon (10a, 10b, 10n ) de ligne, en utilisant d'une part la courbe transitoire des valeurs de courant et de tension mesurées à son bout (12a, 12b, 12n) de ligne, et d'autre part le courant nodal et la tension nodale, ainsi que le modèle d'onde progressive pour ce tronçon (10a, 10b, 10n) de ligne, un détermination bilatérale de l'emplacement du défaut, dans lequel
- lors de la détermination du courant nodal et de la tension nodale, on exclut les valeurs de courant et de tension du bout (12a, 12b, 12n) de ligne, qui limite le tronçon (10a, 10b, 10n) de ligne considéré respectivement pour la détermination de l'emplacement du défaut.

14. Système de détermination d'un emplacement d'un défaut sur une ligne (10) d'un réseau d'alimentation en énergie électrique comprenant :

- plusieurs dispositifs de mesure, qui sont conçus pour mesurer des courbes transitoires de valeurs de courant et de tension aux bouts (12a, 12b, 12n) de la ligne (10) ; et
- au moins un dispositif informatique, qui est conçu pour, en utilisant les courbes transitoires des valeurs de courant et de tension, déterminer, après l'apparition d'un défaut sur la ligne (10), l'emplacement (F) du défaut ;

dans lequel

- la ligne (10) a un premier tronçon (10a) ayant un premier bout (12a), un deuxième tronçon (10b) ayant un deuxième bout (12b) et au moins un autre tronçon (10n) ayant un autre bout (10n), ainsi qu'au moins un point (11) nodal où plus de deux des tronçons (10a, 10b, 10n) de la ligne se rencontrent,
- le dispositif informatique est conçu pour déterminer des courbes transitoires d'un courant nodal et d'une tension nodale au au moins un point (11) nodal, en utilisant au moins les valeurs de courant et de tension d'un bout (12a, 12b, 12n) de ligne, ainsi qu'un modèle d'onde progressive pour le tronçon (10a, 10b, 10b) de ligne respectif ; et
- le dispositif informatique est conçu pour effectuer pour chaque tronçon (10a, 10b, 10n ) de ligne, en utilisant d'une part la courbe transitoire des valeurs de courant et de tension mesurées à son bout (12a, 12b, 12n) de ligne, et d'autre part le courant nodal et la tension nodale, ainsi que le modèle d'onde progressive pour ce tronçon (10a, 10b, 10n) de ligne, un détermination bilatérale de l'emplacement du défaut, dans lequel
- lors de la détermination du courant nodal et de la tension nodale, on exclut les valeurs de courant et de tension du bout (12a, 12b, 12n) de ligne, qui limite le tronçon (10a, 10b, 10n) de ligne considéré respectivement pour la détermination de l'emplacement du défaut.

FIG 1

FIG 2

# FIG 3

## FIG 4

$$z = \underline{Z}_c \sinh \gamma l$$

$$y = \frac{1}{\underline{Z}_c} \tanh \frac{\gamma l}{2}$$

$$\frac{1}{\underline{Z}_c} \tanh \frac{\gamma l}{2}$$

$p$   $I_p$   $I_q$   $q$

$U_p$   $U_q$

## FIG 5

$l$

$l-x$   $x$

11a   13b

F

12b

10b

$I$   $U$

50

# FIG 6

# FIG 7

FIG 8

$$\begin{bmatrix} A_1 & -B_1 \\ -C_1 & D_1 \end{bmatrix} \qquad \begin{bmatrix} A_n & -B_n \\ -C_n & D_n \end{bmatrix}$$

80a                    80n

FIG 9

$$z = B$$

$$y = \frac{A-1}{B}$$

$$y = \frac{A-1}{B}$$

FIG 10

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4996624 A
- US 5929642 A
- US 8655609 B2

- EP 3193420 A1
- EP 3223026 A1
- EP 3477808 A1